(19) Europäisches Patentamt
European Patent Office
Office européen des brevets

(11) EP 4 722 150 A1

(12) EUROPEAN PATENT APPLICATION
published in accordance with Art. 153(4) EPC

(43) Date of publication:
**08.04.2026 Bulletin 2026/15**

(21) Application number: **24872222.5**

(22) Date of filing: **25.09.2024**

(51) International Patent Classification (IPC):
***C01B 21/072*** (2006.01) ***C01B 21/064*** (2006.01)
***C08K 9/06*** (2006.01) ***C08L 101/00*** (2006.01)
***C09C 3/08*** (2006.01) ***C23C 16/42*** (2006.01)

(52) Cooperative Patent Classification (CPC):
**C01B 21/064; C01B 21/072; C08K 9/06; C08L 101/00; C09C 3/08; C23C 16/42**

(86) International application number:
**PCT/JP2024/034033**

(87) International publication number:
**WO 2025/070435 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.09.2023 JP 2023163239**

(71) Applicant: **Resonac Corporation**
**Tokyo 105-7325 (JP)**

(72) Inventors:
- **IEMURA, Takeshi**
  **Tokyo 105-7325 (JP)**
- **MINORIKAWA, Naoki**
  **Tokyo 105-7325 (JP)**

(74) Representative: **Strehl & Partner mbB**
**Maximilianstrasse 54**
**80538 München (DE)**

# (54) METHOD FOR PRODUCING NITRIDE FILLER COATED WITH ORGANOSILICON-CONTAINING COMPOUND AND HAVING SILANOL GROUP, AND METHOD FOR PRODUCING SILICA-COATED NITRIDE FILLER COATED WITH ORGANOSILICON-CONTAINING COMPOUND AND HAVING SILANOL GROUP

(57) Provided are a method for producing an organosilicon-containing compound-coated nitride filler having a silanol group and a method for producing an organosilicon-containing compound-coated silica-coated nitride filler having a silanol group, which enable a reduction in viscosity of a slurry obtained by mixing with a resin monomer to be controlled.

A method for producing an organosilicon-containing compound-coated nitride filler having a silanol group includes a first step A of covering the surface of a nitride filler with an organosilicone compound containing a specific structure to obtain an organosilicon-containing compound-coated nitride filler and a second step A of treating the surface of the organosilicon-containing compound-coated nitride filler with a specific basic substance to obtain an organosilicon-containing compound-coated nitride filler having a silanol group on the surface, or a first step P of causing the organosilicone compound and the basic substance to coexist in the same atmosphere, and simultaneously treating the organosilicone compound and the basic substance to cover the surface of the nitride filler, thereby obtaining an organosilicon-containing compound-coated nitride filler having a silanol group on the surface.

EP 4 722 150 A1

## Description

### Technical Field

The present invention relates to an organosilicon-containing compound-coated nitride filler having a silanol group and a production method thereof, as well as an organosilicon-containing compound-coated silica-coated nitride filler having a silanol group and a production method thereof.

### Background Art

Nitride fillers have high thermal conductivity and excellent electrical insulating properties. This means that nitride fillers are a promising material as a filler in a resin composition used for products such as heat dissipating sheets and sealing agents for electronic parts. Among nitride fillers, aluminum nitride may undergo hydrolysis upon reacting with moisture, resulting in denaturization into aluminum hydroxide, which has low thermal conductivity. The hydrolysis of aluminum nitride may also generate ammonia, which is corrosive.

The hydrolysis of aluminum nitride proceeds even in the presence of atmospheric moisture. Therefore, under high-temperature and high-humidity conditions, aluminum nitride-containing products may suffer not only from a decrease in moisture resistance and thermal conductivity, but also from a decrease in performance due to corrosion caused by ammonia generated by the hydrolysis of the aluminum nitride.

Technologies for improving the moisture resistance of aluminum nitride that have been proposed include a method of forming a layer composed of Si-Al-O-N on the surface of an aluminum nitride powder (for example, see Patent Literature 1), a method of forming a coating layer on the surface of an aluminum nitride powder with a silicate treatment agent and a coupling agent (for example, see Patent Literature 2), a method in which a treatment is performed with a silicate treatment agent to leave an organic group on the surface of an aluminum nitride powder (for example, see Patent Literature 3), a method in which the surface of aluminum nitride particles is surface-modified using a specific acidic phosphate ester (for example, see Patent Literature 4), and an improvement method that provides even better moisture resistance and thermal conductivity (for example, see Patent Literature 5).

In the moisture-proof aluminum nitride powder of Patent Literature 1, a silicate ester layer is applied on the surface of the aluminum nitride powder, and then calcination is performed at a high temperature of 350 to 1000°C to form a layer composed of Si-Al-C-N on the surface.

In the aluminum nitride powder of Patent Literature 2, a coating layer is formed on the surface by performing a surface treatment with a silicate treatment agent and a coupling agent, and then carrying out a high-temperature heat treatment. In the aluminum nitride powder of Patent Literature 3, a surface treatment is performed with a silicate treatment agent, and a heat treatment is then carried out at a temperature of not more than 90°C to leave an organic group and thus improve compatibility with the resin.

In the surface-modified particles of Patent Literature 4, aluminum nitride particles are surface-modified with a specific acidic phosphate ester to improve moisture resistance. In the surface-modified particles of Patent Literature 5, aluminum nitride particles having excellent moisture resistance are formed by coating with an extremely thin, homogeneous, and dense silica film.

Further, boron nitride, also used in various heat dissipating materials due to having a high thermal conductivity, does not suffer from the moisture resistance problems of aluminum nitride, and also takes advantage of having a low dielectric constant, and thus is being developed for various applications. However, even with boron nitride, the primary particles are plate-shaped, and so not only are there few active sites where the silane coupling agent can act on, those active sites are localized at the ends. As a result, boron nitride suffers from a problem in terms of compatibility with the resin and the problem that the slurry viscosity tends to increase.

### Citation List

### Patent Literature

PTL 1: JP 3446053 B

PTL 2: JP 4088768 B

PTL 3: JP 4804023 B

PTL 4: JP 2015-71730 A

PTL 5: WO 2020/040309 A1

## Summary of Invention

### Technical Problem

However, an aluminum nitride powder or a moisture-resistant silica-coated aluminum nitride powder suffers from problems in terms of compatibility with silicone resins and in reducing the viscosity of the silicone monomer slurry. In particular, there is a need for further improvement in compatibility when attempting to blend aluminum nitride powder at a high filling rate.

In particular, in Patent Literature 5, in which high thermal conductivity is maintained and excellent moisture resistance can be achieved, there is a need for further reduction in slurry viscosity.

Further, regarding boron nitride, the primary particles of boron nitride are plate-shaped, and so the viscosity of the slurry increases significantly especially at high filling rates, and in a silane coupling agent treatment using a common process, it is not possible to obtain a sufficient effect of reducing the viscosity of the slurry. In other words, the true value of a heat dissipating filler should be evaluated based on the product of two characteristics, namely, the thermal properties of the powder itself and how high the powder can be filled into the resin while maintaining moldability. Therefore, the effect of reducing slurry viscosity is as important as the thermal properties.

The present invention has been created in view of such circumstances, and it is an object of the present invention to provide a method for producing an organosilicon-containing compound-coated nitride filler having a silanol group and a method for producing an organosilicon-containing compound-coated silica-coated nitride filler having a silanol group, which enable a reduction in viscosity of a slurry obtained by mixing with a resin monomer to be controlled.

### Solution to Problem

As a result of intensive studies, the present inventors discovered that the problems described above can be solved by using a specific organosilicon compound and a specific basic substance to coat the surface of a nitride filler or silica-coated nitride filler using a specific method, to thereby complete the present invention. That is, the present invention has the following configuration.

[1] A method for producing an organosilicon-containing compound-coated nitride filler having a silanol group, which includes a nitride filler and an organosilicon-containing compound film that covers a surface of the nitride filler and has a silanol group on a surface, the method including:

a first step A of covering the surface of the nitride filler with an organosilicone compound containing a structure represented by the following formula (1) to obtain an organosilicon-containing compound-coated nitride filler covered with the organosilicone compound, and a second step A of treating the surface of the organosilicon-containing compound-coated nitride filler with a basic substance to obtain an organosilicon-containing compound-coated nitride filler having a silanol group on the surface, or

a first step P of causing an organosilicone compound containing a structure represented by the following formula (1) and the basic substance to coexist in the same atmosphere, and simultaneously treating the organosilicone compound and the basic substance to cover the surface of the nitride filler, thereby obtaining an organosilicon-containing compound-coated nitride filler having a silanol group on the surface,

[Formula 1]

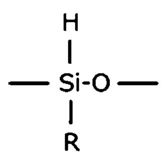 · · · (1)

wherein, in formula (1), R is an alkyl group having from 1 to 4 carbon atoms.

[2] The method for producing an organosilicon-containing compound-coated nitride filler having a silanol group according to the above [1], wherein in the second step A, the basic substance is ammonia water, and the treatment is performed by immersion in the ammonia water.

[3] The method for producing an organosilicon-containing compound-coated nitride filler having a silanol group according to the above [1], wherein in the second step A, the basic substance is ammonia water, and the treatment is

performed by a chemical vapor deposition (CVD) method.

[4] The method for producing an organosilicon-containing compound-coated nitride filler having a silanol group according to the above [1], wherein in the first step P, the basic substance is ammonia water, and the treatment is performed by a chemical vapor deposition (CVD) method simultaneously with the organosilicone compound.

[5] The method for producing an organosilicon-containing compound-coated nitride filler having a silanol group according to any of the above [1] to [4], wherein the nitride filler is aluminum nitride particles or boron nitride particles.

[6] The method for producing an organosilicon-containing compound-coated nitride filler having a silanol group according to the above [5], wherein a cumulative volume 50% particle size (D50) of the aluminum nitride particles is 0.1 μm or more and 200 μm or less.

[7] The method for producing an organosilicon-containing compound-coated nitride filler having a silanol group according to any of the above [1] to [6], wherein a surface treatment agent is attached to the surface of the organosilicon-containing compound-coated nitride filler having a silanol group by a reaction or an interaction.

[8] The method for producing an organosilicon-containing compound-coated nitride filler having a silanol group according to the above [7], wherein the surface treatment agent is a silane coupling agent.

[9] An organosilicon-containing compound-coated nitride filler having a silanol group, including:

a nitride filler; and
an organosilicon-containing compound film that covers a surface of the nitride filler and has silanol groups on the surface in an average surface density of from 0.5 to 2.1 groups/$nm^2$.

[10] The organosilicon-containing compound-coated nitride filler having a silanol group according to the above [9], further including a surface treatment agent on the surface of the organosilicon-containing compound-coated nitride filler having a silanol group.

[11] The organosilicon-containing compound-coated nitride filler having a silanol group according to the above [10], wherein the surface treatment agent is a silane coupling agent.

[12] A method for producing an organosilicon-containing compound-coated silica-coated nitride filler having a silanol group, which includes a silica-coated nitride filler and an organosilicon-containing compound film that covers a surface of the silica-coated nitride filler and has a silanol group on a surface, the method including:

a first step B of covering the surface of the silica-coated nitride filler with an organosilicone compound containing a structure represented by the following formula (1) to obtain an organosilicon-containing compound-coated silica-coated nitride filler covered with the organosilicone compound, and a second step B of treating the surface of the organosilicon-containing compound-coated silica-coated nitride filler with a basic substance to obtain an organosilicon-containing compound-coated silica-coated nitride filler having a silanol group on the surface, or
a first step Q of causing an organosilicone compound containing a structure represented by the following formula (1) and the basic substance to coexist in the same atmosphere, and simultaneously treating the organosilicone compound and the basic substance to cover the surface of the silica-coated nitride filler, thereby obtaining an organosilicon-containing compound-coated silica-coated nitride filler having a silanol group on the surface,

[Formula 2]

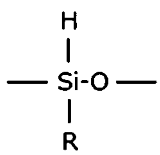

· · · (1)

wherein, in formula (1), R is an alkyl group having from 1 to 4 carbon atoms.

[13] The method for producing an organosilicon-containing compound-coated silica-coated nitride filler having a silanol group according to the above [12], wherein in the second step B, the basic substance is ammonia water, and the treatment is performed by immersion in the ammonia water.

[14] The method for producing an organosilicon-containing compound-coated silica-coated nitride filler having a silanol group according to the above [12], wherein in the second step B, the basic substance is ammonia water, and the treatment is performed by a chemical vapor deposition (CVD) method.

[15] The method for producing an organosilicon-containing compound-coated silica-coated nitride filler having a silanol group according to the above [12], wherein in the first step Q, the basic substance is ammonia water, and the treatment is performed by a chemical vapor deposition (CVD) method simultaneously with the organosilicone

compound.

[16] The method for producing an organosilicon-containing compound-coated silica-coated nitride filler having a silanol group according to any of the above [12] to [15], wherein the nitride filler is aluminum nitride particles or boron nitride particles.

[17] The method for producing an organosilicon-containing compound-coated silica-coated nitride filler having a silanol group according to the above [16], wherein a cumulative volume 50% particle size (D50) of the aluminum nitride particles is 0.1 μm or more and 200 μm or less.

[18] The method for producing an organosilicon-containing compound-coated silica-coated nitride filler having a silanol group according to any of the above [12] to [17], wherein a surface treatment agent is attached to the surface of the organosilicon-containing compound-coated silica-coated nitride filler having a silanol group by a reaction or an interaction.

[19] The method for producing an organosilicon-containing compound-coated silica-coated nitride filler having a silanol group according to the above [18], wherein the surface treatment agent is a silane coupling agent.

[20] An organosilicon-containing compound-coated silica-coated nitride filler having a silanol group, including:

a silica-coated nitride filler; and
an organosilicon-containing compound film that covers a surface of the silica-coated nitride filler and has silanol groups on the surface in an average surface density of from 0.5 to 2.1 groups/$nm^2$.

[21] The organosilicon-containing compound-coated silica-coated nitride filler having a silanol group according to the above [20], further including a surface treatment agent on the surface of the organosilicon-containing compound-coated silica-coated nitride filler having a silanol group.

[22] The organosilicon-containing compound-coated silica-coated nitride filler having a silanol group according to the above [21], wherein the surface treatment agent is a silane coupling agent.

Advantageous Effects of Invention

According to the present invention, it is possible to provide a method for producing an organosilicon-containing compound-coated nitride filler having a silanol group and a method for producing an organosilicon-containing compound-coated silica-coated nitride filler having a silanol group, which enable a reduction in viscosity of a slurry obtained by mixing with a resin monomer to be controlled.

Description of Embodiments

The present invention will now be described in detail.

The present invention also includes modes in which the matters described in this specification are freely selected or freely combined.

In this specification, preferable provisions can be freely selected, and combinations of preferable provisions can be said to be more preferable.

In this specification, the expression "from XX to YY" means "XX or more and YY or less".

In this specification, the lower limit value and upper limit value described in a stepwise manner in relation to preferable numerical ranges (for example, content ranges and the like) can each be independently combined. For example, the description "preferably from 10 to 90, and more preferably from 30 to 60" can combine "preferable lower limit value (10)" and "more preferable upper limit value (60)" and be read as "from 10 to 60".

In this specification, the deposition methods in the "vapor-phase deposition method" and "vapor-phase simultaneous deposition method" relating to the treatment of the basic substance include deposition methods using chemical vapor deposition (CVD).

In this specification, the "cumulative volume 50% particle size (D50)" indicates the particle size at which the cumulative volume value is 50% for a certain particle size distribution. The D50 is determined from a particle size distribution obtained by a laser diffraction scattering method. Specifically, the D50 can be measured by using a laser diffraction/scattering particle size distribution measuring instrument (manufactured by Microtrac Bell Co., Ltd., trade name: Microtrac MT3300EX2) or the like.

<Method for producing an organosilicon-containing compound-coated nitride filler having a silanol group>

The method for producing an organosilicon-containing compound-coated nitride filler having a silanol group according to the present invention, which includes a nitride filler and an organosilicon-containing compound film that covers a surface of the nitride filler and has a silanol group on a surface, is characterized by including:

a first step A of covering the surface of the nitride filler with an organosilicone compound containing a structure represented by the following formula (1) to obtain an organosilicon-containing compound-coated nitride filler covered with the organosilicone compound, and a second step A of treating the surface of the organosilicon-containing compound-coated nitride filler with a basic substance to obtain an organosilicon-containing compound-coated nitride filler having a silanol group on the surface, or

a first step P of causing an organosilicone compound containing a structure represented by the following formula (1) and the basic substance to coexist in the same atmosphere, and simultaneously treating the organosilicone compound and the basic substance to cover the surface of the nitride filler, thereby obtaining an organosilicon-containing compound-coated nitride filler having a silanol group on the surface.

[Formula 3]

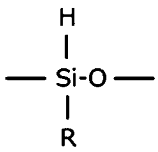

· · · (1)

In formula (1), R is an alkyl group having from 1 to 4 carbon atoms.

[First step A]

This step is a step of covering the surface of a nitride filler with an organosilicone compound containing the structure represented by the above formula (1) to obtain the above-described nitride filler covered with the organosilicone compound.

<Nitride filler>

In the method for producing an organosilicon-containing compound-coated nitride filler having a silanol group according to the present invention, examples of the nitride filler used as a raw material include aluminum nitride, boron nitride, and silicon nitride.

Among these, aluminum nitride and boron nitride are preferred from the viewpoint of having high thermal conductivity and from the viewpoint of serving as a filler for a resin composition.

(Aluminum nitride particles)

When aluminum nitride particles are used as a raw material in the method for producing an organosilicon-containing compound-coated nitride filler having a silanol group according to the present invention, a commercially available product or other such known aluminum nitride particles can be used.

The method for producing the aluminum nitride particles is not particularly limited, and examples include a direct nitriding method in which a metal aluminum powder is directly reacted with nitrogen or ammonia, a reduction nitriding method in which a nitriding reaction is performed at the same time as heating alumina in a nitrogen or ammonia atmosphere while reducing with carbon.

Further, as the aluminum nitride particles, particles obtained by sintering an aggregate of aluminum nitride particles into granules can be used, and, for example, sintered granules produced using high-purity aluminum nitride particles as a raw material can be suitably used.

Here, high-purity aluminum nitride particles are particles having a low oxygen content and few metal impurities. Specifically, for example, high-purity aluminum nitride particles having an oxygen content of 1% by mass or less and a total content of metal impurities (that is, metal atoms other than aluminum) of 1000 ppm by mass or less are suitable for obtaining a higher thermal conductivity for the aluminum nitride particles contained in the organosilicon-containing compound-coated aluminum nitride particles.

The aluminum nitride particles can be used alone or in combination.

The oxygen content described above can be measured with an inorganic analyzer or the like that is equipped with an infrared detector for oxygen detection. Specifically, the oxygen content can be measured using an oxygen/nitrogen/-hydrogen analyzer (ONH836: manufactured by LECO Japan Corporation) or the like.

Further, the total content of metal atoms other than aluminum can be measured using an ICP (Inductively Coupled Plasma) mass spectrometer or the like. Specifically, the total content of metal atoms other than aluminum can be measured using an ICP mass spectrometer (ICPMS-2030: manufactured by Shimadzu Corporation).

The shape of the aluminum nitride particles used in the present invention is not particularly limited, and examples thereof include amorphous (crushed), spherical, elliptical, plate-like shape, and the like. In addition, when dispersing and containing organosilicon-containing compound-coated aluminum nitride particles in a resin composition as a filler, aluminum nitride particles of the same type (single aluminum nitride particles) having the same shape and structure may be used alone as the aluminum nitride particles, but it is also possible to use a mixture of aluminum nitride particles in which two or more different types of aluminum nitride particles having different shapes and structures are mixed in various proportions.

When dispersing and containing organosilicon-containing compound-coated aluminum nitride particles having a silanol group in a resin composition, the larger the volume ratio (filling amount) of the aluminum nitride particles constituting the organosilicon-containing compound-coated aluminum nitride particles having a silanol group is with respect to the resin composition, the higher the thermal conductivity of the resin composition becomes. Therefore, the shape of the aluminum nitride particles is preferably close to a spherical shape so that the viscosity of the resin composition is less likely to increase due to the addition of the organosilicon-containing compound-coated aluminum nitride particles.

The cumulative volume 50% particle size (D50) of the aluminum nitride particles used in the present invention is not particularly limited, but is preferably 0.1 μm or more, more preferably 0.3 μm or more and 200.0 μm or less, further preferably 0.4 μm or more and 100.0 μm or less, and particularly preferably 0.5 μm or more and 85.0 μm or less.

If the D50 of the aluminum nitride particles is within the above range, even when a resin composition containing organosilicon-containing compound-coated aluminum nitride particles is used as a heat dissipating material to be mounted on a power electronic component, a thin heat dissipating material having a minimum thickness can be provided, and perhaps because the film can easily cover the surface of the aluminum nitride particles uniformly, the moisture resistance of the aluminum nitride particles is further improved.

(Boron nitride particles)

When boron nitride particles are used as a raw material in the method for producing an organosilicon-containing compound-coated nitride filler having a silanol group according to the present invention, a commercially available product or other such known boron nitride particles can be used.

The method for producing the boron nitride particles is not particularly limited, and examples thereof include: (a) a method of directly nitriding boron using nitrogen, ammonia, and the like; (b) a method of reacting a boron halide with ammonia or an ammonium salt; (c) a method of reducing and nitriding a boron compound such as boric acid or boron oxide by reacting the boron compound with a nitrogen-containing compound such as melamine at a temperature of about 800°C; and (d) a method of reducing and nitriding a boron compound by heating the boron compound and a carbon source to a high temperature of 1600°C or higher in a nitrogen atmosphere. Among these, method (d) allows the use of low-cost raw materials and is the most preferred method for producing the boron nitride.

Examples of commercially available products include UHP-1K (manufactured by Resonac, D50: 8.5 μm), UHP-2 (manufactured by Resonac Corporation, D50: 10.5 μm), and UHP-S2 (manufactured by Resonac Corporation, D50: 1.0 μm), and the like.

<Organosilicone compound used for coating>

In the method for producing an organosilicon-containing compound-coated nitride filler having a silanol group according to the present invention, the organosilicone compound used as a raw material for the organosilicon-containing compound film constituting the organosilicon-containing compound-coated nitride filler having a silanol group is an organosilicone compound containing the structure represented by the above formula (1). The organosilicone compound can be used without particular limitation regardless of whether the compound has a linear, cyclic, or branched form. The structure represented by formula (1) is a hydrogen siloxane unit in which the hydrogen is directly bonded to the silicon atom.

In the above formula (1), R, which is an alkyl group having 1 or more and 4 or less carbon atoms, is, from the viewpoint of volatilizing the silicone compound, preferably a methyl group, an ethyl group, a propyl group, a t-butyl group, or the like, and particularly preferably a methyl group. In the method for producing an organosilicon-containing compound-coated nitride filler having a silanol group according to the present invention, the organosilicone compound used as a raw material is, for example, an oligomer or polymer containing the structure represented by formula (1).

The organosilicone compound is preferably, for example, at least one of a compound represented by the following formula (2) and a compound represented by the following formula (3).

[Formula 4]

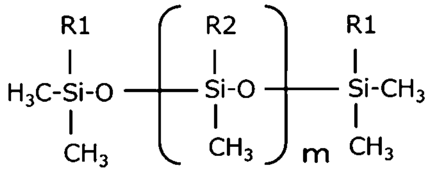

· · · (2)

In formula (2), R1 and R2 are each independently a hydrogen atom or a methyl group, at least one of R1 and R2 is a hydrogen atom, and m is an integer from 0 to 10.

[Formula 5]

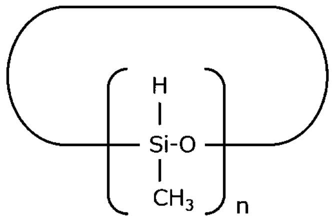

· · · (3)

In formula (3), n is an integer of from 3 to 6.

In particular, a cyclic hydrogen siloxane oligomer in which n is 4 in the above formula (3) is excellent in that a uniform film can be formed on the surface of the aluminum nitride particles. The weight average molecular weight of the organosilicone compound containing the structure represented by formula (1) is preferably 100 or more and 2000 or less, more preferably 150 or more and 1000 or less, and further preferably 180 or more and 500 or less. It is inferred that by using an organosilicone compound having a weight average molecular weight in this range and having the structure represented by formula (1), it is easy to form a thin and uniform film on the surface of the nitride filler.

In this specification, the weight average molecular weight is a polystyrene-equivalent weight average molecular weight using gel permeation chromatography (GPC), and specifically, can be measured by using a column (Shodex (registered trademark) LF-804: manufactured by Resonac Corporation) in combination with a differential refractive index detector (Shodex (registered trademark) RI-71S: manufactured by Resonac Corporation).

In the first step A, the surface of the nitride filler is covered with an organosilicone compound containing the structure represented by the above formula (1).

In the first step A, as long as the surface of the nitride filler can be covered with an organosilicone compound containing the structure represented by the above formula (1), the method is not particularly limited. Examples of the method for the first step A include a dry mixing method in which, using a common powder mixing apparatus, dry mixing is performed by adding the organosilicone compound by spraying while the raw material nitride filler is stirred to thereby coat the nitride filler. Examples of the powder mixing apparatus include a Henschel mixer, a rotary vessel-type V blender, a ribbon blender having mixing blades such as a double cone-type blender, a screw-type blender, a hermetic rotary kiln, and stirring by means of a stirring bar of a hermetic container using magnet coupling. The temperature conditions in this case depend on the boiling point and vapor pressure of the silicone compound containing the structure represented by formula (1), but are preferably, although not particularly limited to, a temperature of 10°C or higher and 200°C or lower, more preferably 20°C or higher and 150°C lower, and further preferably in the range of 40°C or higher and 100°C or lower.

Further, as the method for the first step A, a vapor-phase adsorption method may be used in which vapor of the organosilicone compound containing the structure represented by formula (1) singly or a mixed gas thereof with an inert gas such as nitrogen gas is caused to be attached or deposited onto the nitride filler surface left to stand. The temperature conditions in this case depend on the boiling point and vapor pressure of the silicone compound containing the structure represented by formula (1), but are preferably, although not particularly limited to, a temperature of 10°C or higher and 200°C or lower, more preferably 20°C or higher and 150°C lower, and further preferably in the range of 40°C or higher and 100°C or lower. The treatment time is preferably from 3 to 7 hours, and more preferably from 3.5 to 5 hours. If necessary, the inside of the system may be pressurized or depressurized [sometimes referred to as chemical vapor deposition (CVD) method]. As an apparatus that can be used in this case, an apparatus which is a hermetic system and in which the gas in the system can be easily replaced is preferable, and, for example, a CVD apparatus using a glass container or a desiccator can be used. When coating the nitride filler with the organosilicone compound without stirring, it is necessary to take a longer treatment time. However, even in places where the powder particles are hidden due to being in contact with each other, or for powder particles far from the upper air layer, it is possible to perform the treatment more efficiently by intermittently placing the treatment container on a vibrator to cause the powder particles to move.

The amount of the organosilicone compound containing the structure represented by formula (1) used in the first step A is not particularly limited. In the nitride filler covered with the organosilicone compound containing the structure represented by formula (1) obtained in the first step A, the coating amount of the organosilicone compound containing the structure represented by formula (1) is preferably 0.08 mg or more and 20.0 mg or less, more preferably in the range of 0.09 mg or more and 15.0 mg or less, and further preferably in the range of 1.0 mg or more and 10.0 mg or less per 1 $m^2$ of the surface area calculated from the specific surface area ($m^2/g$) of the nitride filler determined by the BET method.

The coating amount of the organosilicone compound containing the structure represented by formula (1) per 1 $m^2$ of the surface area calculated from the specific surface area ($m^2/g$) of the nitride filler determined by the BET method can be determined by dividing the difference between the masses of the nitride filler before and after coating with the organosilicone compound containing the structure represented by formula (1) by the surface area ($m^2$) calculated from the specific surface area ($m^2/g$) of the nitride filler determined by the BET method.

The specific surface area determined by the BET method can be measured by the nitrogen adsorption BET single-point method using a gas flow method. As the evaluation device, a Macsorb HM model-1210 manufactured by Mountech Co., Ltd can be used.

[Second step A]

This step is a step of treating the surface of the organosilicon-containing compound-coated nitride filler obtained in the first step A with a basic substance to obtain an organosilicon-containing compound-coated nitride filler having a silanol group on the surface.

Specifically, this step is a step in which the surface of the organosilicon-containing compound-coated nitride filler obtained in the first step A is treated with a basic substance to convert an -Si-H group (active hydrogen group) into an -Si-OH group (silanol group).

The basic substance may be from a weak base to a strong base, from a Bronsted base to Lewis base, and is not particularly limited as long as a basic aqueous solution that is so strong that solid content remains is not used. Examples thereof include ammonia water, monoethylamine, diethylamine, triethylamine, 2-ethanolamine, and the like. From the viewpoint of ease of separation, ammonia water is preferable.

The treatment uses an immersion method or a vapor-phase deposition method.

(Immersion method)

The immersion method is a deposition method in which the organosilicon-containing compound-coated nitride filler obtained in the first step A is immersed into an aqueous solution or the like of a basic substance, causing the basic substance to react with the surface of the organosilicon-containing compound-coated nitride filler, to thereby convert an -Si-H group (active hydrogen group) into an -Si-OH group (silanol group).

The basic substance in the second step A is preferably ammonia water, and the treatment is preferably performed by immersion in the ammonia water.

In the immersion method, the concentration of the basic substance is not particularly limited, but, for example, when ammonia water is used as the basic substance, from the viewpoint of the reaction rate, the concentration is preferably 0.01 N or more and 10 N or less, and from the viewpoint of suppressing side reactions of the remaining organosilicone compound and reducing risk in the working environment, the concentration is more preferably 0.1 N or more and 5 N or less, and further preferably 0.5 N or more and 1.5 N or less.

The amount of the ammonia water is not particularly limited, but, for example, when the particle size (D50) of the aluminum nitride particles used in the reaction is 30 $\mu$m or more and 100 $\mu$m or less, the amount of ammonia water used in the treatment is preferably from one-third by mass or more to an equivalent amount by mass or less relative to the mass of the particles. Further, when the particle size (D50) is 0.1 $\mu$m or more and less than 30 $\mu$m, the amount of ammonia water used in the treatment is preferably one-half by mass or more to twice the amount by mass or less relative to the mass of the particles.

The immersion is not particularly limited as long as the whole of the particle is immersed in the ammonia water. As the size of the particles becomes smaller, the wetting of the surface of the particles with the ammonia water immediately after immersion tends to be poorer, and so in such a case it is preferable to add the same amount of ethanol as the ammonia water.

The addition of the ethanol improves wetting of the surface of the particles with the ammonia water, and so the ethanol may be further added while stirring. The reaction may be carried out by constant stirring, but may also be satisfactorily carried out by intermittent manual mixing under static conditions. There is no particular limitation on the container for the manual mixing, but it is preferable to use a wide-mouthed polyethylene bottle having a volume that is approximately twice the total volume of the contents.

The treatment temperature is preferably 20°C or higher and 60°C or lower, but since a large amount of hydrogen

is generated immediately after the treatment, for safety reasons it is preferable to start the treatment at 20°C.

The treatment time is preferably 20 hours or more and 30 hours or less, and more preferably 22 hours or more and 27 hours or less.

After the treatment with the basic substance, the basic substance is removed by suction filtration using filter paper. The filtrate is thoroughly washed with distilled water and then with ethanol to facilitate drying. Washing with acetone at the end speeds up the drying. By drying the filtrate at 90°C for 2 hours, for example, an organosilicon-containing compound-coated aluminum nitride particles having a silanol group on the surface or organosilicon-containing compound-coated silica-coated aluminum nitride particles having a silanol group on the surface can be obtained.

(Vapor-phase deposition method)

The vapor-phase deposition method is a deposition method in which an aqueous solution or the like of a basic substance is vapor-deposited onto the organosilicon-containing compound-coated nitride filler obtained in the first step A, causing the basic substance to react with the surface of the organosilicon-containing compound-coated nitride filler, to thereby convert an -Si-H group (active hydrogen group) into an -Si-OH group (silanol group).

The basic substance in the second step A is preferably ammonia water, and the treatment is preferably performed by vapor-phase deposition method.

In the vapor-phase deposition method, the concentration of the basic substance is not particularly limited, but, for example, when ammonia water is used as the basic substance, it is preferable to carry out the vapor-phase deposition in an airtight container with a gas vent hole in an open state, in a place where local ventilation can be achieved. The concentration is preferably 0.01 N or more and 10.0 N or less, and from the viewpoint of suppressing side reactions of the remaining organosilicone compound and reducing risk in the working environment, the concentration is more preferably 0.10 N or more and 5.0 N or less, and further preferably 0.50 N or more and 1.50 N or less.

In the case of the vapor-phase deposition method, the reaction rate is lower than in the immersion method using ammonia water, and therefore the treatment temperature is preferably 20°C or higher and 80°C or lower, more preferably 20°C or higher and 70°C or lower, and further preferably 30°C or higher and 60°C or lower.

The treatment time in the vapor-phase deposition method using ammonia water is from 24 to 48 hours when the treatment temperature is 20°C, but the treatment time can be shortened by increasing the treatment temperature. For example, when the treatment is performed at 50°C, sufficient silanol groups can be introduced in 4 to 5 hours.

[First step P]

This step is a step of causing the above-described organosilicone compound containing a structure represented by formula (1) and the above-described basic substance to coexist in the same atmosphere, and simultaneously treating the organosilicone compound and the basic substance to cover the surface of the nitride filler, thereby obtaining an organosilicon-containing compound-coated nitride filler having a silanol group on the surface.

The treatment uses a vapor-phase simultaneous deposition method.

(Vapor-phase simultaneous deposition method)

The vapor-phase simultaneous deposition method is a method involving causing the organosilicone compound and the basic substance to coexist in the same atmosphere, and simultaneously treating the organosilicone compound containing the structure represented by the above formula (1) and the basic substance to convert an -Si-H group (active hydrogen group) of the organosilicone compound on the surface of the nitride filler into an -Si-OH group (silanol group).

In the first step P, from the viewpoint of replenishing the moisture essential for the reaction by using ammonia water, which is a volatile basic substance, the basic substance in the first step P is preferably ammonia water, and the treatment is preferably performed by a vapor-phase simultaneous deposition method.

In the vapor-phase simultaneous deposition method, the concentration of the basic substance is not particularly limited, but, for example, when ammonia water is used as the basic substance, it is preferable to carry out the vapor-phase deposition in an airtight container with a gas vent hole in an open state, in a place where local ventilation can be achieved. The concentration is preferably 0.01 N or more and 10.0 N or less, and from the viewpoint of suppressing side reactions of the remaining organosilicone compound and reducing risk in the working environment, the concentration is more preferably 0.10 N or more and 5.0 N or less, and further preferably 0.50 N or more and 1.50 N or less.

In the case of the vapor-phase simultaneous deposition method, the treatment temperature depends on the boiling point and vapor pressure of the silicone compound containing the structure represented by formula (1), but is preferably 40°C or higher and 65°C or lower, more preferably 45°C or higher and 65°C or lower, and further preferably 50°C or higher and 65°C or lower.

The treatment time depends on the treatment temperature, but is preferably 3 hours or more and 12 hours or less,

more preferably 4 hours or more and 10 hours or less, and further preferably 5 hours or more and 7 hours or less. When the concentration and temperature are outside these ranges, the reaction time is too long or the reaction is too vigorous, which is not preferable.

After completion of the vapor-phase simultaneous deposition method, it is preferable to dry at 90°C for 2 hours.

<Method for producing an organosilicon-containing compound-coated silica-coated nitride filler having silanol group>

The method for producing an organosilicon-containing compound-coated silica-coated nitride filler having a silanol group according to the present invention, which includes a silica-coated nitride filler and an organosilicon-containing compound film that covers a surface of the silica-coated nitride filler and has a silanol group on a surface, is characterized by including:

a first step B of covering the surface of the silica-coated nitride filler with an organosilicone compound containing a structure represented by the following formula (1) to obtain an organosilicon-containing compound-coated silica-coated nitride filler covered with the organosilicone compound, and a second step B of treating the surface of the organosilicon-containing compound-coated silica-coated nitride filler with a basic substance to obtain an organosilicon-containing compound-coated silica-coated nitride filler having a silanol group on the surface, or

a first step Q of causing an organosilicone compound containing a structure represented by the following formula (1) and the basic substance to coexist in the same atmosphere, and simultaneously treating the organosilicone compound and the basic substance to cover the surface of the silica-coated nitride filler, thereby obtaining an organosilicon-containing compound-coated silica-coated nitride filler having a silanol group on the surface,

[Formula 6]

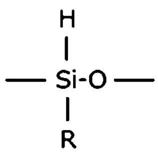

・・・(1)

In formula (1), R is an alkyl group having from 1 to 4 carbon atoms.

[First step B]

This step is a step of covering the surface of a silica-coated nitride filler with an organosilicone compound containing the structure represented by the above formula (1) to obtain the above-described silica-coated nitride filler covered with the organosilicone compound.

(Silica-coated aluminum nitride particles)

In the method for producing the organosilicon-containing compound-coated silica-coated nitride filler particles having a silanol group according to the present invention, the silica-coated aluminum nitride particles used as a raw material can be prepared using the above-mentioned aluminum nitride and using, for example, the method described in [0040] to [0061] of WO 2020/040309 A1.

(Silica-coated boron nitride particles)

In the method for producing the organosilicon-containing compound-coated silica-coated nitride filler particles having a silanol group according to the present invention, the silica-coated boron nitride particles used as a raw material can be prepared using the above-mentioned boron nitride and using, for example, the method described in [0040] to [0061] of WO 2020/040309 A1.

<Organosilicone compound used for coating>

In the method for producing an organosilicon-containing compound-coated silica-coated nitride filler particles having a silanol group according to the present invention, the organosilicone compound used as a raw material for the organosilicon-containing compound film constituting the organosilicon-containing compound-coated silica-coated nitride filler particles is an organosilicone compound containing the structure represented by the above formula (1). The

organosilicone compound can be used without particular limitation regardless of whether the compound has a linear, cyclic, or branched form. The structure represented by formula (1) is a hydrogen siloxane unit in which the hydrogen is directly bonded to the silicon atom.

In the above formula (1), R, which is an alkyl group having 1 or more and 4 or less carbon atoms, is, from the viewpoint of volatilizing the silicone compound, preferably a methyl group, an ethyl group, a propyl group, a t-butyl group, or the like, and particularly preferably a methyl group. In the method for producing an organosilicon-containing compound-coated silica-coated nitride filler particles having a silanol group according to the present invention, the organosilicone compound used as a raw material is, for example, an oligomer or polymer containing the structure represented by formula (1).

The organosilicone compound is preferably, for example, at least one of a compound represented by the following formula (2) and a compound represented by the following formula (3).

[Formula 7]

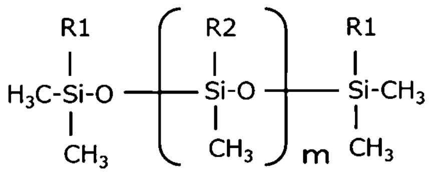

· · · (2)

In formula (2), R1 and R2 are each independently a hydrogen atom or a methyl group, at least one of R1 and R2 is a hydrogen atom, and m is an integer from 0 to 10.

[Formula 8]

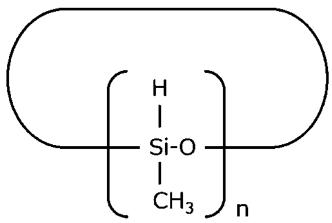

· · · (3)

In formula (3), n is an integer of from 3 to 6.

In particular, a cyclic hydrogen siloxane oligomer in which n is 4 in the above formula (3) is excellent in that a uniform film can be formed on the surface of the aluminum nitride particles. The weight average molecular weight of the organosilicone compound containing the structure represented by formula (1) is preferably 100 or more and 2000 or less, more preferably 150 or more and 1000 or less, and further preferably 180 or more and 500 or less. It is presumed that by using an organosilicone compound having a weight average molecular weight in this range and having the structure represented by formula (1), it is easy to form a thin and uniform film on the surface of the nitride filler. In formula (2), m is preferably 1.

In the first step B, the surface of the silica-coated nitride filler is covered with an organosilicone compound containing the structure represented by the above formula (1).

In the first step B, as long as the surface of the silica-coated nitride filler can be covered with an organosilicone compound containing the structure represented by the above formula (1), the method is not particularly limited. Examples of the method for the first step B include a dry mixing method in which, using a common powder mixing apparatus, dry mixing is performed by adding the organosilicone compound by spraying while the raw material silica-coated nitride filler is stirred to thereby coat the nitride filler. Examples of the powder mixing apparatus include a Henschel mixer, a rotary vessel-type V blender, a ribbon blender having mixing blades such as a double cone-type blender, a screw-type blender, a hermetic rotary kiln, and stirring by means of a stirring bar of a hermetic container using magnet coupling. The temperature conditions in this case depend on the boiling point and vapor pressure of the silicone compound containing the structure represented by formula (1), but are preferably, although not particularly limited to, a temperature of 10°C or higher and 200°C or lower, more preferably 20°C or higher and 150°C lower, and further preferably in the range of 40°C or higher and 100°C or lower.

Further, as the method for the first step B, a vapor-phase adsorption method may be used in which vapor of the organosilicone compound containing the structure represented by formula (1) singly or a mixed gas thereof with an inert gas such as nitrogen gas is caused to be attached or deposited onto the silica-coated nitride filler surface left to stand. The temperature conditions in this case depend on the boiling point and vapor pressure of the silicone compound containing

the structure represented by formula (1), but are preferably, although not particularly limited to, a temperature of 10°C or higher and 200°C or lower, more preferably 20°C or higher and 150°C lower, and further preferably in the range of 40°C or higher and 100°C or lower. The treatment time is preferably from 3 to 7 hours, and more preferably from 3.5 to 5 hours. If necessary, the inside of the system may be pressurized or depressurized [sometimes referred to as chemical vapor deposition (CVD) method]. As an apparatus that can be used in this case, an apparatus which is a hermetic system and in which the gas in the system can be easily replaced is preferable, and, for example, a glass container, a desiccator, or a CVD apparatus can be used. When coating the silica-coated nitride filler with the organosilicone compound without stirring, it is necessary to take a longer treatment time.

However, even in places where the powder particles are hidden due to being in contact with each other, or for powder particles far from the upper air layer, it is possible to perform the treatment more efficiently by intermittently placing the treatment container on a vibrator to cause the powder particles to move.

The amount of the organosilicone compound containing the structure represented by formula (1) used in the first step B is not particularly limited. In the silica-coated nitride filler covered with the organosilicone compound containing the structure represented by formula (1) obtained in the first step B, the coating amount of the organosilicone compound containing the structure represented by formula (1) is preferably 0.08 mg or more and 20.0 mg or less, more preferably in the range of 0.09 mg or more and 15.0 mg or less, and further preferably in the range of 1.0 mg or more and 10.0 mg or less per 1 $m^2$ of the surface area calculated from the specific surface area ($m^2/g$) of the silica-coated nitride filler determined by the BET method. If the coating amount is too large, the thermal conductivity will decrease, and if the coating amount is too small, the moisture resistance will be insufficient.

The coating amount of the organosilicone compound containing the structure represented by formula (1) per 1 $m^2$ of the surface area calculated from the specific surface area ($m^2/g$) of the silica-coated nitride filler determined by the BET method can be determined by dividing the difference between the masses of the silica-coated nitride filler before and after coating with the organosilicone compound by the surface area ($m^2$) calculated from the specific surface area ($m^2/g$) of the silica-coated nitride filler determined by the BET method.

The specific surface area determined by the BET method can be measured by the nitrogen adsorption BET single-point method using a gas flow method. As the evaluation device, a Macsorb HM model-1210 manufactured by Mountech Co., Ltd can be used.

[Second step B]

In this step, the surface of the organosilicon-containing compound-coated silica-coated nitride filler obtained in the first step B is treated with a basic substance to obtain an organosilicon-containing compound-coated silica-coated nitride filler having a silanol group on the surface.

Specifically, this step is a step in which the surface of the organosilicon-containing compound-coated silica-coated nitride filler obtained in the first step B is treated with a basic substance to convert an -Si-H group (active hydrogen group) into an -Si-OH group (silanol group).

As the basic substance, the same substance as in the above second step A can be used, and preferable basic substances and the like are also the same.

The treatment uses, similarly to in the above second step A, an immersion method or a vapor-phase deposition method.

(Immersion method)

The immersion method is a deposition method in which the organosilicon-containing compound-coated silica-coated nitride filler obtained in the first step B is immersed into an aqueous solution of a basic substance, causing the basic substance to react with the surface of the organosilicon-containing compound-coated silica-coated nitride filler, to thereby convert an -Si-H group (active hydrogen group) into an -Si-OH group (silanol group), as shown in the following formula (Z).

[Formula 9]

$$-Si-H + H_2O \xrightarrow{NH_3} -Si-OH + H_2 \qquad (Z)$$

The basic substance in the second step B is preferably ammonia water, and the treatment is preferably performed by immersion in the ammonia water.

In the immersion method, the concentration of the basic substance is not particularly limited, but, for example,

when ammonia water is used as the basic substance, from the viewpoint of the reaction rate, the concentration is preferably 0.01 N or more and 10.0 N or less, and from the viewpoint of suppressing side reactions of the remaining organosilicone compound and reducing risk in the working environment, the concentration is more preferably 0.10 N or more and 5.0 N or less, and further preferably 0.50 N or more and 1.50 N or less.

The amount of the ammonia water is, for example, when the particle size (D50) of the silica-coated aluminum nitride particles used in the reaction is 30 μm or more and 100 μm or less, the amount of ammonia water used in the treatment is preferably from one-third by mass or more to an equivalent amount by mass or less relative to the mass of the particles. Further, when the particle size (D50) is 0.1 μm or more and less than 30 μm, the amount of ammonia water used in the treatment is preferably one-half by mass or more to twice the amount by mass or less relative to the mass of the particles.

The immersion is not particularly limited as long as about one-third of the particle is immersed in the ammonia water. As the size of the particles becomes smaller, the wetting of the surface of the particles with the ammonia water immediately after immersion tends to be poorer, so in such a case it is preferable to add the same amount of ethanol as the ammonia water. The addition of the ethanol improves wetting of the surface of the particles with the ammonia water, so the ethanol may be further added while stirring. The reaction may be carried out by constant stirring, but may also be satisfactorily carried out by intermittent manual mixing under static conditions. There is no particular limitation on the container for the manual mixing, but it is preferable to use a wide-mouthed polyethylene bottle having a volume that is approximately twice the total volume of the contents.

The treatment temperature is preferably 20°C or higher and 60°C or lower, but since a large amount of hydrogen is generated immediately after the treatment, for safety reasons it is preferable to treat from 20°C.

The treatment time is preferably 20 hours or more and 30 hours or less, and more preferably 22 hours or more and 27 hours or less.

After the treatment with the basic substance, the basic substance is removed by suction filtration using filter paper. The filtrate is thoroughly washed with distilled water and then with ethanol to facilitate drying. Washing with acetone at the end speeds up the drying. By drying the filtrate at 90°C for 2 hours, for example, organosilicon-containing compound-coated silica-coated aluminum nitride particles having a silanol group on the surface can be obtained.

(Vapor-phase deposition method)

The vapor-phase deposition method is a deposition method in which an aqueous solution or the like of a basic substance is vapor-deposited onto the organosilicon-containing compound-coated silica-coated nitride filler obtained in the first step B, causing the basic substance to react with the surface of the organosilicon-containing compound-coated silica-coated nitride filler, to thereby convert an -Si-H group (active hydrogen group) into an -Si-OH group (silanol group), as shown in the above formula (Z).

The basic substance in the second step B is preferably ammonia water, and the treatment is preferably performed by vapor-phase deposition method.

In the vapor-phase deposition method, the concentration of the basic substance is not particularly limited, but, for example, when ammonia water is used as the basic substance, it is preferable to carry out the vapor-phase deposition in an airtight container with a gas vent hole in an open state, in a place where local ventilation can be achieved. The concentration is preferably 0.01 N or more and 10 N or less, and from the viewpoint of suppressing side reactions of the remaining organosilicone compound and reducing risk in the working environment, the concentration is more preferably 0.1 N or more and 5 N or less, and further preferably 0.5 N or more and 1.5 N or less.

In the case of the vapor-phase deposition method, the reaction rate is lower than in the immersion method using ammonia water, and therefore the treatment temperature is preferably 20°C or higher and 80°C or lower, more preferably 20°C or higher and 70°C or lower, and further preferably 30°C or higher and 60°C or lower.

The treatment time in the vapor-phase deposition method using ammonia water requires about from 24 to 48 hours when the treatment temperature is 20°C, but the treatment time can be shortened by increasing the treatment temperature. For example, when the treatment is performed at 50°C, sufficient silanol groups can be introduced in about 4 to 5 hours.

After completion of the treatment with the basic substance, it is preferable to dry at 90°C for 2 hours.

[First step Q]

This step is a step of causing the above-described organosilicone compound containing a structure represented by formula (1) and the above-described basic substance to coexist in the same atmosphere, and simultaneously treating the organosilicone compound and the basic substance to cover the surface of the silica-coated nitride filler, thereby obtaining an organosilicon-containing compound-coated silica-coated nitride filler having a silanol group on the surface.

The treatment uses a vapor-phase simultaneous deposition method.

(Vapor-phase simultaneous deposition method)

The vapor-phase simultaneous deposition method is a deposition method involving causing the organosilicone compound and the basic substance to coexist in the same atmosphere, and simultaneously treating the organosilicone compound containing the structure represented by the above formula (1) and the basic substance to convert an -Si-H group (active hydrogen group) of the organosilicone compound on the surface of the silica-coated nitride filler into an -Si-OH group (silanol group) for deposition.

In the first step Q, from the viewpoint of replenishing the moisture essential for the reaction by using ammonia water, which is a volatile basic substance, the basic substance in the first step Q is preferably ammonia water, and the treatment is preferably performed by a vapor-phase simultaneous deposition method.

In the vapor-phase simultaneous deposition method, the concentration of the basic substance is not particularly limited, but, for example, when ammonia water is used as the basic substance, it is preferable to carry out the vapor-phase deposition in an airtight container with a gas vent hole in an open state, in a place where local ventilation can be achieved. The concentration is preferably 0.01 N or more and 10.0 N or less, and from the viewpoint of suppressing side reactions of the remaining organosilicone compound and reducing risk in the working environment, the concentration is more preferably 0.10 N or more and 5.0 N or less, and further preferably 0.50 N or more and 1.50 N or less.

In the case of the vapor-phase simultaneous deposition method, the treatment temperature depends on the boiling point and vapor pressure of the silicone compound containing the structure represented by formula (1), but is preferably 40°C or higher and 65°C or lower, more preferably 45°C or higher and 65°C or lower, and further preferably 50°C or higher and 65°C or lower.

The treatment time depends on the treatment temperature, but is preferably 3 hours or more and 12 hours or less, more preferably 4 hours or more and 10 hours or less, and further preferably 5 hours or more and 7 hours or less.

After completion of the vapor-phase simultaneous deposition method, it is preferable to dry at 90°C for 2 hours.

(Surface treatment agent)

It is preferable that the surface treatment agent is attached to the surface of the organosilicon-containing compound-coated nitride filler having a silanol group or the organosilicon-containing compound-coated silica-coated nitride filler having a silanol group obtained in the present invention by a reaction or an interaction.

As the surface treatment agent, a silane coupling agent, a compound having one or more of an amino group, a carboxyl group, and an epoxy group, or modified silicone oil, and the like is used. Among these, a silane coupling agent is preferably used.

As the silane coupling agent, any known compound can be used as long as the silicon atom has a hydrolyzable substituent such as a halogen atom or an alkoxy group. For example, it is preferable to use vinyltrichlorosilane, vinyltrimethoxysilane, β-(3,4-epoxycyclohexyl)ethyltrimethoxysilane, γ-glycidoxypropyltriethoxysilane, γ-methacryloxypropyltrimethoxysilane, γ-aminopropyltriethoxysilane, N-phenyl-γ-aminopropyltrimethoxysilane, γ-chloropropyltrimethoxysilane, γ-mercaptopropyltrimethoxysilane, n-hexyltrimethoxysilane, n-octyltrimethoxysilane, n-decyltrimethoxysilane (manufactured by Shin-Etsu Silicone Co., Ltd., KBM-3103), n-dodecyltrimethoxysilane, phenyltriethoxysilane, diphenyldimethoxysilane, hexamethyldisilazane (manufactured by Shin-Etsu Silicone Co., Ltd., SZ-31). These silane coupling agents can be used alone or in combination.

As the compound having one or more of an amino group, a carboxyl group, and an epoxy group, a compound that easily adsorbs to or reacts with the surface of each nitride filler through an action of these groups is preferable, and a known compound can be used.

For example, 1,2-epoxyhexane, 1,2-epoxydodecane, n-hexylamine, n-dodecylamine, p-n-hexylaniline, n-hexylcarboxylic acid, n-dodecylcarboxylic acid, p-n-hexylbenzoic acid, and the like are preferrable.

As the modified silicone oil, it is preferable to use KF-105, KF-101, KF-102, X-22-173DX, KF-393, KF-864, KF-8012, KF-857, X-22-3667, X-22-162A, and X-22-3701E (manufactured by Shin-Etsu Chemical Co., Ltd.), TSF4700, TSF4701, TSF4702, TSF4703, TSF4730*, TSF4770, and TSE3070 (manufactured by Momentive Performance Materials Inc.), SF8417, BY16-828, BY16-849, BY16-892, BY16-853, BY16-837, SF8411, BY16-875, BY16-855, SF 8421, SF8418, and BY16-874 (manufactured by DuPont Toray Specialty Materials K.K.), and the like, and these can be used alone or in combination.

There is no particular limitation on the method for coating these compounds onto the organosilicon-containing compound-coated nitride filler having a silanol group or organosilicon-containing compound-coated silica-coated nitride filler having a silanol group, and a known method can be used.

For example, a direct method in which a surface treatment is performed on the filler in advance may be used. Examples of the direct method include a dry method, an impregnation method, and an integral method. In the dry method, a chemical is added dropwise to the filler and mixed under stirring, and in some cases, the solvent used to dilute the chemical and the reaction byproducts are evaporated to dryness. In the impregnation method, the filler is immersed in a surface

treatment agent solution, mixed under stirring, filtered, and then the solvent and reaction byproducts are evaporated to dryness. In the integral method, a surface treatment agent is added during kneading with a polymer.

Examples of the apparatus used to perform the treatment include a Henschel mixer, a Nauta mixer, and the like. Examples of the apparatus used to perform the mixing include a kneader, a planetary mixer, and the like. Examples of the drying method include oven drying and natural drying, and a used known method is used.

The coating amount of the silane coupling agent on the organosilicon-containing compound-coated nitride filler having a silanol group or organosilicon-containing compound-coated silica-coated nitride filler having a silanol group is preferably from 0.05% by mass to 10.0% by mass with respect to the nitride filler or silica-coated nitride filler. By setting the coating amount to 0.05% by mass or more, it is easier to obtain a coating effect. By setting the coating amount to 10.0% by mass or less, the content of unreacted silane coupling agent and the like decreases, and so unreacted silane coupling agent is less likely to remain as an impurity.

The charging ratio of the silane coupling agent is, from the viewpoint of a slurry flow viscosity reduction effect and prevention of filler aggregation due to unreacted silane coupling agent, preferably from 0.5 to 180 times, more preferably from 1.0 to 120 times, and further preferably from 2.0 to 100 times.

The charging ratio of the silane coupling agent represents the ratio when the charging amount calculated from the BET specific surface area of the nitride filler and the minimum coating area of the silane coupling agent is 1. The minimum coating area of the silane coupling agent is calculated using the following formula based on the molecular weight of the silane coupling agent.

$$\text{Minimum coating area } [m^2/g] = 6.02\times10^{23}\times13\times10^{-20}/\text{molecular weight of silane coupling agent}$$

[Method for producing resin composition]

A resin composition can be produced using an organosilicon-containing compound-coated nitride filler having a silanol group surface treated with the organosilicon-containing compound-coated nitride filler having a silanol group obtained by the production method according to the present invention, or an organosilicon-containing compound-coated silica-coated nitride filler having a silanol group surface treated with the organosilicon-containing compound-coated silica-coated nitride filler having a silanol group.

That is, the method for producing a resin composition according to the present invention may include a production step of producing an organosilicon-containing compound-coated nitride filler having a silanol group, a production step of producing a surface-treated organosilicon-containing compound-coated nitride filler having a silanol group, and a mixing step of mixing a surface-treated organosilicon-containing compound-coated nitride filler having a silanol group and a resin, by the method for producing an organosilicon-containing compound-coated nitride filler having a silanol group and the method for producing a surface-treated organosilicon-containing compound-coated nitride filler having a silanol group.

Alternatively, the method for producing a resin composition according to the present invention may include a production step of producing an organosilicon-containing compound-coated silica-coated nitride filler having a silanol group, a production step of producing a surface-treated organosilicon-containing compound-coated silica-coated nitride filler having a silanol group, and a mixing step of mixing a surface-treated organosilicon-containing compound-coated silica-coated nitride filler having a silanol group and a resin, by the method for producing an organosilicon-containing compound-coated silica-coated nitride filler having a silanol group and the method for producing a surface-treated organosilicon-containing compound-coated silica-coated nitride filler having a silanol group.

In the mixing step, a surface-treated organosilicon-containing compound-coated nitride filler having a silanol group produced by the above-described method for producing the organosilicon-containing compound-coated nitride filler having a silanol group and a resin are mixed.

Alternatively, in the mixing step, a surface-treated organosilicon-containing compound-coated silica-coated nitride filler having a silanol group produced by the above-described method for producing the organosilicon-containing compound-coated silica-coated nitride filler having a silanol group and a resin are mixed.

The resin to be mixed in the mixing step is not particularly limited, but from the viewpoint of heat resistance, examples of the resin include a thermosetting resin, a thermoplastic resin, and a mixture of a thermosetting resin and a thermoplastic resin. From the viewpoint of controlling the viscosity of the slurry, a thermosetting resin having a functional group (for example, a vinyl group, an allyl group, or the like) capable of reacting with an active hydrogen group, or a thermosetting resin into which such a group has been introduced, is preferable. Examples of the thermosetting resin include a silicone resin such as polydimethylsiloxane, an epoxy resin, a phenol resin, a bismaleimide resin, a cyanate resin, a urethane resin, a (meth)acrylic resin, a vinylester resin, an unsaturated polyester resin, a polyvinyl alcohol acetal resin, and the like. These may be used alone or as a mixture of two or more. In addition, a mixture may be used in which a curing agent or a curing accelerator has been added to the thermosetting resin. In particular, an epoxy resin is preferable in terms of having good heat resistance, adhesiveness, and electrical properties after curing, and a silicone resin is preferable for applications in which flexible adhesiveness is important.

Silicone resins include addition reaction-curable silicone resins, condensation reaction-curable silicone resins, organic peroxide-curable silicone resins, and the like. These silicone resins may be used alone or in combination of two or more having different viscosities. In particular, when the resulting resin composition is used for applications in which flexible adhesiveness is important, examples of the silicone resin include an addition reaction-curable liquid silicone resin in which no by-products that might act as a causative substance for air bubbles and the like are produced. A cured product of the silicone resin can be obtained by reacting an alkenyl group-containing organopolysiloxane, which serves as a base polymer, with an Si-H group-containing organopolysiloxane, which serves as a cross-linking agent, at ordinary temperature or an elevated temperature in the presence of a curing agent. Specific examples of the organopolysiloxane serving as a base polymer include an organopolysiloxane having, as the alkenyl group, a vinyl group, an allyl group, a propenyl group, a hexenyl group, and the like. In particular, a vinyl group is preferable for the organopolysiloxane. Further, as the curing catalyst, for example, a platinum metal-based curing catalyst may be used. The amount added may also be adjusted to achieve a desired hardness of the cured resin.

Examples of the epoxy resin include a bifunctional glycidyl ether epoxy resin such as a bisphenol A epoxy resin, a bisphenol F epoxy resin, a bisphenol S epoxy resin, a hydrogenerated bisphenol A epoxy resin, and a biphenyl epoxy resin; a glycidyl ester epoxy resin such as a hexahydrophthalic acid glycidyl ester and a dimer acid glycidyl ester; a linear aliphatic epoxy resin such as epoxidized polybutadiene and epoxidized soybean oil; a heterocyclic epoxy resin such as triglycidyl isocyanurate; a glycidyl amine epoxy resin such as N,N,N',N'-tetraglycidyl-4,4'-diaminodiphenylmethane, N,N,N',N'-tetraglycidyl-1,3-benzenedi(methanamine), 4-(glycidyloxy)-N,N-diglycidyl aniline, and 3-(glycidyloxy)-N,N-diglycidyl aniline; a polyfunctional glycidyl ether epoxy resin such as a phenol novolak epoxy resin, a cresol novolak epoxy resin, a biphenylaralkyl epoxy resin, a naphthalenearalkyl epoxy resin, a tetrafunctional naphthalene epoxy resin, and a triphenylmethane epoxy resin; and the like. These epoxy resins may be used alone or as a mixture of two or more.

When the above-described epoxy resin is used, a curing agent or a curing accelerator may be added. Examples of the curing agent include an alicyclic acid anhydride such as methyltetrahydrophthalic anhydride, methylhexahydrophthalic anhydride, and himic acid anhydride; an aliphatic acid anhydride such as dodecenyl succinic anhydride; an aromatic acid anhydride such as phthalic anhydride and trimellitic anhydride; a bisphenol such as bisphenol A, bisphenol F, and bisphenol S; a phenol resin such as a phenol formaldehyde resin, a phenol aralkyl resin, a naphthol aralkyl resin, and a phenol-dicyclopentadiene copolymer resin; an organic dihydrazide such as dicyandiamide and adipic acid dihydrazide. Examples of the curing catalyst include an amine such as tris(dimethylaminomethyl)phenol, dimethylbenzylamine, 1,8-diazabicyclo(5,4,0)undecene, and derivatives thereof; an imidazole such as 2-methylimidazole, 2-ethyl-4-methylimidazole, and 2-phenylimidazole, and derivatives thereof. These may be used alone or in combination of two or more.

In the mixing step, in addition to the organosilicon-containing compound-coated nitride filler having a silanol group or the organosilicon-containing compound-coated silica-coated nitride filler having a silanol group, a commonly used filler such as alumina, silica, and zinc oxide may also be used together.

In the mixing step, the surface-treated organosilicon-containing compound-coated nitride filler having a silanol group and a filler other than the surface-treated organosilicon-containing compound-coated nitride filler having a silanol group, or the surface-treated organosilicon-containing compound-coated silica-coated nitride filler having a silanol group and a filler other than the surface-treated organosilicon-containing compound-coated silica-coated nitride filler having a silanol group, may be mixed in amounts sufficient to form the desired resin composition.

In the resulting resin composition, the total content by volume of the surface-treated organosilicon-containing compound-coated nitride filler having a silanol group and the filler other than the surface-treated organosilicon-containing compound-coated nitride filler having a silanol group, or the total content by volume of the surface-treated organosilicon-containing compound-coated silica-coated nitride filler having a silanol group and the filler other than the surface-treated organosilicon-containing compound-coated silica-coated nitride filler having a silanol group, is, respectively, preferably 50% by volume or more and 99% by volume or less, more preferably 60% by volume or more and 97% by volume or less, and further preferably 70% by volume or more and 95% by volume or less. When the total content by volume is 50% by volume or more, good heat dissipation properties can be exhibited, and when the total content by volume is 99% by volume or less, good workability can be obtained when using the resin composition.

The content by volume of the surface-treated organosilicon-containing compound-coated nitride filler having a silanol group in the resulting resin composition is preferably 30% by volume or more and 100% by volume or less, more preferably 40% by volume or more and 100% by volume or less, and further preferably 50% by volume or more and 100% by volume or less of the total content by volume of the surface-treated organosilicon-containing compound-coated nitride filler having a silanol group and the filler other than the surface-treated organosilicon-containing compound-coated nitride filler having a silanol group. When the total content by volume is 30% by volume or more, good heat dissipation properties can be exhibited.

Further, the total content by volume of the surface-treated organosilicon-containing compound-coated silica-coated nitride filler having a silanol group in the resulting resin composition is preferably 30% by volume or more and 100% by volume or less, more preferably 40% by volume or more and 100% by volume or less, and further preferably 50% by volume or more and 100% by volume or less of the total content by volume of the surface-treated organosilicon-containing

compound-coated silica-coated nitride filler having a silanol group and the filler other than the surface-treated organosilicon-containing compound-coated silica-coated nitride filler having a silanol group. When the total content by volume is 30% by volume or more, good heat dissipation properties can be exhibited.

In the mixing step, a flexibility-conferring agent such as silicone, urethane acrylate, a butyral resin, an acrylic rubber, a diene rubber, and copolymers thereof, a silane coupling agent, a titanium coupling agent, an inorganic ion scavenger, a pigment, a dye, a diluent, a solvent, and the like may optionally be further added as appropriate.

There is no particular limitation on the mixing method in the mixing step, but, for example, a method may be used in which the surface-treated organosilicon-containing compound-coated nitride filler having a silanol group, or the surface-treated organosilicon-containing compound-coated silica-coated nitride filler having a silanol group, the resin, other additives, and the like are all at once or in portions mixed, dissolved, and kneaded, if required, with heating, using a dispersing/dissolving machine such as a stone mill, a planetary mixer, a planetary centrifugal mixer, a kneader, and a roll mill alone or in combination.

The resulting resin composition may be formed into a sheet-like shape and, if required, reacted to provide a heat dissipating sheet. The resin composition and heat dissipating sheet described above may be suitably used for adhesive applications for semiconductor power devices, power modules, and the like.

<Organosilicon-containing compound-coated nitride filler having a silanol group>

The organosilicon-containing compound-coated nitride filler having a silanol group according to the present invention is characterized by including a nitride filler and an organosilicon-containing compound film that covers a surface of the nitride filler and has silanol groups on the surface in an average surface density of from 0.5 to 2.1 groups/$nm^2$.

(Average surface density of silanol groups)

The average surface density of silanol groups in the organosilicon-containing compound-coated nitride filler having a silanol group is from 0.5 to 2.1 groups/$nm^2$. When the average surface density is less than 0.5 groups/$nm^2$, a sufficient slurry thinning effect cannot be obtained. The maximum number of silanol groups that can be introduced is roughly determined based on the type of the organosilicone material used in the CVD, but even if the treatment temperature is set to 50°C or higher in order to increase the reaction rate or the treatment time is extended, the maximum number will not exceed 2.1 groups/$nm^2$.

The average surface density of silanol groups is, from the viewpoint of obtaining a sufficient slurry thinning effect, preferably from 0.6 to 2.1 groups/$nm^2$, and more preferably from 0.7 to 2.1 groups/$nm^2$.

A reduction in the average surface density of silanol groups can be freely controlled by heat treating the organosilicone substance in the range of 150°C to 250°C for 2 hours after the CVD treatment but before the ammonia water treatment. The temperature and the time can be set freely based on the cumulative amount of heat received, but as a guideline, the average surface density of silanol groups can be reduced to about two-thirds of 1.3 groups/$nm^2$ at 150°C for 2 hours, and to about one-fourth at 200°C for 2 hours.

In the present invention, the average surface density of silanol groups in the organosilicon-containing compound-coated nitride filler having a silanol group can be measured, for example, by the method described in the Examples below.

It is preferable that the surface of the organosilicon-containing compound-coated nitride filler having a silanol group further have a surface treatment agent.

As the surface treatment agent, a silane coupling agent, a compound having one or more of an amino group, a carboxyl group, and an epoxy group, modified silicone oil, and the like is used. Among these, from the viewpoint of reactivity with the silanol groups on the surface of the organosilicon-containing compound-coated nitride filler having a silanol group, the surface treatment agent is preferably a silane coupling agent.

The coating amount of the silane coupling agent and the like on the organosilicon-containing compound-coated nitride filler having a silanol group is preferably from 0.05% by mass to 5.0% by mass with respect to the organosilicon-containing compound-coated nitride filler having a silanol group. By setting the coating amount to 0.05% by mass or more, it is easier to obtain a coating effect. By setting the coating amount to 5.0% by mass or less, the content of unreacted silane coupling agent and the like decreases, and so unreacted silane coupling agent is less likely to remain as an impurity.

<Organosilicon-containing compound-coated silica-coated nitride filler having a silanol group>

The organosilicon-containing compound-coated silica-coated nitride filler having a silanol group according to the present invention is characterized by including a silica-coated nitride filler and an organosilicon-containing compound film that covers a surface of the silica-coated nitride filler and has silanol groups on the surface in an average surface density of from 0.5 to 2.1 groups/$nm^2$.

(Average surface density of silanol groups)

The average surface density of silanol groups in the organosilicon-containing compound-coated silica-coated nitride filler having a silanol group is from 0.5 to 2.1 groups/$nm^2$. When the average surface density is less than 0.5 groups/$nm^2$, a sufficient slurry thinning effect cannot be obtained. The maximum number of silanol groups that can be introduced is roughly determined based on the type of the organosilicone material used in the CVD, but even if the treatment temperature is set to 50°C or higher in order to increase the reaction rate or the treatment time is extended, the maximum number will not exceed 2.1 groups/$nm^2$.

The average surface density of silanol groups is, from the viewpoint of obtaining a sufficient slurry thinning effect, preferably from 0.6 to 2.1 groups/$nm^2$, and more preferably from 0.7 to 2.1 groups/$nm^2$.

A reduction in the average surface density of silanol groups can be freely controlled by heat treating the organosilicone substance in the range of 150°C to 250°C for 2 hours after the CVD treatment but before the ammonia water treatment. The temperature and the time can be set freely based on the cumulative amount of heat received, but as a guideline, the average surface density of silanol groups can be reduced to about two-thirds of 1.3 groups/$nm^2$ at 150°C for 2 hours, and to about one-fourth at 200°C for 2 hours.

In the present invention, the average surface density of silanol groups in the organosilicon-containing compound-coated silica-coated nitride filler having a silanol group can be measured, for example, by the method described in the Examples below.

It is preferable that the surface of the organosilicon-containing compound-coated silica-coated nitride filler having a silanol group further have a surface treatment agent.

As the surface treatment agent, a silane coupling agent, a compound having one or more of an amino group, a carboxyl group, and an epoxy group, or modified silicone oil, and the like is used. Among these, from the viewpoint of reactivity with the silanol groups on the surface of the organosilicon-containing compound-coated silica-coated nitride filler having a silanol group, the surface treatment agent is preferably a silane coupling agent.

The coating amount of the silane coupling agent and the like on the organosilicon-containing compound-coated silica-coated nitride filler having a silanol group is preferably from 0.05% by mass to 5.0% by mass with respect to the organosilicon-containing compound-coated silica-coated nitride filler having a silanol group. By setting the coating amount to 0.05% by mass or more, it is easier to obtain a coating effect. By setting the coating amount to 5.0% by mass or less, the content of unreacted silane coupling agent and the like decreases, and so unreacted silane coupling agent is less likely to remain as an impurity.

Examples

Next, the present invention will be specifically described with reference to examples, but the present invention is not limited to these examples in any way.

[Preparation of silica-coated aluminum nitride particles]

The surface of aluminum nitride particles A was coated using a vacuum desiccator that was made of 20 mm-thick acrylic resin with internal dimensions of 260 mm × 260 mm × 100 mm, and was divided into a top tier and a bottom tier by a partition having through holes.

First, 200 g of aluminum nitride particles A (FAN-f80-A1: manufactured by Furukawa Electric Co., Ltd.) having a cumulative volume 50% particle size (D50) of 80 μm and a specific surface area of 0.08 $m^2$/g based on the BET method were spread evenly on a stainless steel tray and left to stand in the upper tier of the vacuum desiccator.

Next, 20 g of organosilicone compound A (2,4,6,8-tetramethylcyclotetrasiloxane (D4H), manufactured by Tokyo Chemical Industry Co., Ltd.) where n = 4 in formula (3) was placed in a φ120 glass petri dish and left to stand in the lower tier of the vacuum desiccator. Further, the vacuum desiccator was sealed, and a CVD treatment was carried out at 80°C for 8 hours using an oven. Then, the sample was transferred to an alumina crucible and subjected to a heat treatment at 850°C for 6 hours to obtain silica-coated aluminum nitride particles A.

Silica-coated aluminum nitride particles B were obtained in the same manner as above, except that the aluminum nitride particles A were replaced with aluminum nitride particles B (TFZ-N01P, manufactured by Toyo Aluminum K.K.) having a cumulative volume 50% particle size (D50) of 1.0 μm and a specific surface area of 2.4 $m^2$/g based on the BET method, and the heat treatment at 850°C for 6 hours was changed to a heat treatment at 700°C for 3 hours.

(Example 1)

[Preparation (immersion method) and surface treatment of silica-coated aluminum nitride particles into which silanol group is introduced]

11.0 g of 2,4,6,8-tetramethylcyclotetrasiloxane (D4H) in a φ50 glass petri dish was set in the lower portion of an 8 L pressure-resistant container made of SUS. Next, 200 g of the above-described silica-coated aluminum nitride particles A were placed into a tray made of aluminum foil, and set on a raised bottom drainboard made of SUS at the top of the 8L SUS pressure-resistant container. The lid of the 8 L pressure-resistant container was shut, and the 8 L pressure-resistant container was left to stand in an oven maintained at 80°C for 10 minutes in a sealed state. After releasing the pressure, a CVD treatment was performed for 4.5 hours in the oven maintained at 80°C in a sealed state (D4H concentration: D4H partial pressure $1.30\times10^4$ Pa (80°C)) [CVD 1 treatment].

Next, 200 g of 1 N ammonia water was charged into a 1 L polyethylene wide-mouthed bottle, the entire amount of the CVD-treated sample was added thereto. The mixture was manually stirred every hour for the first 3 hours, and then left to stand in equipment having local ventilation at room temperature for 24 hours. The polyethylene wide-mouthed bottle was not tightly capped while it was left to stand, allowing the generated hydrogen to leak out from a gap in the cap. After 24 hours, vacuum filtration was performed using filter paper coarse enough to maintain the particle size, the filtered material was washed twice with distilled water and twice with ethanol, and dried at 90°C for 2 hours to obtain silica-coated aluminum nitride particles A into which a silanol group is introduced (immersion method).

Next, 2.4 parts by mass of a silane coupling agent (manufactured by Shin-Etsu Silicone Co., Ltd., KBM-3103: decyltrimethoxysilane) was mixed, by an impregnation method, with 100 parts by mass of the silica-coated aluminum nitride particles A into which a silanol group is introduced, and a surface treatment was performed on the silica-coated aluminum nitride particles A into which a silanol group is introduced (SC 1 treatment). It is noted that the charging ratio of the silane coupling agent was 90. Then, after leaving to stand to dry at room temperature for 2 hours, a heat treatment was performed at 120°C for 2 hours using a dryer to obtain a specimen of silica-coated aluminum nitride particles A into which a silanol group is introduced obtained by surface treating the silica-coated aluminum nitride particles A into which a silanol group is introduced with a silane coupling agent.

The charging ratio of the silane coupling agent represents the ratio when the charging amount calculated from the BET specific surface area of the aluminum nitride particles A and the minimum coating area of the silane coupling agent is 1. The minimum coating area of the silane coupling agent is calculated using the following formula based on the molecular weight of the silane coupling agent.

Minimum coating area [$m^2/g$] = $6.02\times10^{23}\times13\times10^{-20}$/molecular weight of silane coupling agent

Table 3 shows the CVD treatment conditions, Table 4 shows the basic substance treatment conditions, and Table 5 shows the silane coupling agent treatment conditions in Example 1, Examples 2 to 11 described later, and Comparative Examples 1 to 11 described later.

(Example 2)

A specimen of silica-coated aluminum nitride particles A obtained by surface treating the silica-coated aluminum nitride particles A into which a silanol group is introduced with a silane coupling agent was obtained in the same manner as Example 1, except that the CVD treatment conditions were 80°C for 1 hour and the D4H concentration had a D4H partial pressure of $8.12\times10^2$ Pa (80°C) [CVD 2 treatment].

(Example 3)

A specimen of silica-coated aluminum nitride particles A obtained by surface treating the silica-coated aluminum nitride particles A into which a silanol group is introduced with a silane coupling agent was obtained in the same manner as Example 1, except that the CVD treatment conditions were 80°C for 1 hour and the D4H concentration had a D4H partial pressure of $2.03\times10^2$ Pa (80°C) [CVD 3 treatment].

(Example 4)

A specimen of silica-coated aluminum nitride particles A obtained by surface treating with a silane coupling agent the silica-coated aluminum nitride particles A into which a silanol group is introduced was obtained in the same manner as Example 1, except that 100 ml of 1 N ammonia water and 100 ml of ethanol were charged into the 1 L polyethylene wide-mouthed bottle, the entire amount of the CVD-treated sample was added, the mixture was manually stirred every hour for the first 3 hours, and then left to stand in equipment having local ventilation at room temperature for 24 hours.

(Example 5)

[Preparation (vapor-phase deposition method) and surface treatment of silica-coated aluminum nitride particles into which silanol group is introduced]

11.0 g of 2,4,6,8-tetramethylcyclotetrasiloxane (D4H) in a φ50 glass petri dish was set in the lower portion (lowest tier) of an 8 L pressure-resistant container made of SUS. Next, 200 g of the above-described silica-coated aluminum nitride particles A were placed into a tray made of aluminum foil, and set on a raised bottom drainboard made of SUS at the top of the 8L SUS pressure-resistant container. The lid of the 8 L pressure-resistant container was shut, and the 8 L pressure-resistant container was left to stand in an oven maintained at 80°C for 10 minutes in a sealed state. After releasing the pressure, a CVD treatment was performed for 4 hours in the oven maintained at 80°C in a sealed state (D4H concentration: D4H partial pressure $1.30 \times 10^4$ Pa (80°C)) [CVD 4 treatment].

Next, the φ50 glass petri dish containing the D4H-treated silica-coated aluminum nitride particles A that had been set in the lower portion (lowest tier) of the 8 L pressure-resistant container was removed, and in its place 20 g of 1 N ammonia water was placed in a φ120 glass petri dish and set in the lower portion (lowest tier) of the 8 L pressure-resistant container. Then, the φ50 glass petri dish containing the D4H-treated silica-coated aluminum nitride particles A was again set thereabove. The lid was shut, the samples were left for 24 hours at room temperature with one pressure vent hole open, the samples were then removed, and dried at 90°C for 2 hours to obtain silica-coated aluminum nitride particles A into which a silanol group is introduced (vapor-phase deposition method).

Next, 2.4 parts by mass of a silane coupling agent (manufactured by Shin-Etsu Silicone Co., Ltd., KBM-3103: decyltrimethoxysilane) was mixed, by an impregnation method, with 100 parts by mass of the silica-coated aluminum nitride particles A into which a silanol group is introduced, and a surface treatment was performed (SC 1 treatment). It is noted that the charging ratio of the silane coupling agent was 90. Then, after leaving to stand to dry at room temperature for 2 hours, a heat treatment was performed at 120°C for 2 hours using a dryer to obtain a specimen of silica-coated aluminum nitride particles A obtained by surface treating with a silane coupling agent the silica-coated aluminum nitride particles A into which a silanol group is introduced.

(Example 6)

A specimen of silica-coated aluminum nitride particles A obtained by surface treating with a silane coupling agent the silica-coated aluminum nitride particles A into which a silanol group is introduced was obtained in the same manner as Example 1, except that the CVD treatment conditions were 80°C for 4 hours [CVD 4 treatment], for the silane coupling agent treatment conditions, a silane coupling agent (manufactured by Shin-Etsu Silicone Co., Ltd., SZ-31: hexamethyldisilazane) (SC 2 treatment) was used, and the charging ratio of the silane coupling agent was 5.

(Example 7)

[Preparation (vapor-phase simultaneous deposition method) and surface treatment of silica-coated aluminum nitride particles into which silanol group is introduced]

3.0 g of 2,4,6,8-tetramethylcyclotetrasiloxane (D4H) in a φ50 glass petri dish and 20 g of 1 N ammonia water placed in a φ120 glass petri dish were each set in the lower portion of an 8 L pressure-resistant container made of SUS.

Next, 200 g of the above-described silica-coated aluminum nitride particles A were placed in a φ150 glass petri dish, and set on a raised bottom drainboard made of SUS at the top of the 8L SUS pressure-resistant container. The lid of the 8 L pressure-resistant container was shut, and the 8 L pressure-resistant container was left to stand in an oven maintained at 60°C for 10 minutes in a sealed state. After releasing the pressure, a CVD treatment was performed for 4 hours in the oven maintained at 60°C in a sealed state (D4H concentration: D4H partial pressure $7.66 \times 10^2$ Pa (60°C)) [CVD 5 treatment] (vapor-phase simultaneous deposition method).

Next, 2.4 parts by mass of a silane coupling agent (manufactured by Shin-Etsu Silicone Co., Ltd., KBM-3103: decyltrimethoxysilane) was mixed, by an impregnation method, with 100 parts by mass of the silica-coated aluminum nitride particles A into which a silanol group is introduced, and a surface treatment was performed (SC 1 treatment). It is noted that the charging ratio of the silane coupling agent was 90. Then, after leaving to stand to dry at room temperature for 2 hours, a heat treatment was performed at 120°C for 2 hours using a dryer to obtain a specimen of silica-coated aluminum nitride particles obtained by surface treating with a silane coupling agent the silica-coated aluminum nitride particles A into which a silanol group is introduced.

(Example 8)

A specimen of silica-coated aluminum nitride particles A obtained by surface treating with a silane coupling agent the silica-coated aluminum nitride particles A into which a silanol group is introduced was obtained in the same manner as Example 5, except that the treatment temperature of the ammonia was 50°C and the treatment time was 4 hours.

(Example 9)

A specimen of silica-coated aluminum nitride particles B obtained by surface treating with a silane coupling agent the silica-coated aluminum nitride particles B into which a silanol group is introduced was obtained by operating in the same manner as Example 5, except that the silica-coated aluminum nitride particles A were changed to the silica-coated aluminum nitride particles B, the treatment temperature of the ammonia was 50°C, the treatment time was 4 hours, and the charging ratio of the silane coupling agent was 2.

(Example 10)

A specimen of boron nitride particles A obtained by surface treating with a silane coupling agent the boron nitride particles A into which a silanol group is introduced was obtained by operating in the same manner as Example 5, except that silica-coated aluminum nitride particles A having a cumulative volume 50% particle size (D50) of 8.5 μm were used, boron nitride particles A (UHP-1K, Resonac Corporation) having a specific surface area based on the BET method of 4 $m^2/g$ were used, the treatment temperature of the ammonia was 50°C, the treatment time was 4 hours, and the charging ratio of the silane coupling agent was 2.

(Example 11)

A specimen of boron nitride particles B obtained by surface treating with a silane coupling agent the boron nitride particles B into which a silanol group is introduced was obtained by operating in the same manner as Example 5, except that silica-coated aluminum nitride particles B having a cumulative volume 50% particle size (D50) of 1.0 μm and a specific surface area based on the BET method of 9 $m^2/g$ (UHP-S2, Resonac Corporation) were used in place of boron nitride particles A, the treatment temperature of the ammonia was 50°C, the treatment time was 4 hours, and the charging ratio of the silane coupling agent was 2.

(Example 12)

A specimen of silica-coated aluminum nitride particles A into which a silanol group is introduced was obtained in the same manner as Example 8, except that a silane coupling agent treatment was not carried out.

(Comparative Example 1)

A specimen of silica-coated aluminum nitride particles A obtained by surface treating with a silane coupling agent the silica-coated aluminum nitride particles A was obtained by operating in the same manner as Example 1, except that the CVD treatment and the ammonia treatment were not carried out.

(Comparative Example 2)

A specimen of silica-coated aluminum nitride particles A obtained by surface treating with a silane coupling agent the silica-coated aluminum nitride particles A was obtained by operating in the same manner as Example 1, except that the ammonia treatment was not carried out.

(Comparative Example 3)

A specimen of aluminum nitride particles A obtained by surface treating with a silane coupling agent the aluminum nitride particles A was obtained by operating in the same manner as Example 1, except that the silica-coated aluminum nitride particles A were changed to the aluminum nitride particles A, and the CVD treatment and the ammonia treatment were not carried out.

(Comparative Example 4)

Silica-coated aluminum nitride particles A was obtained by operating in the same manner as Example 1, except that the CVD treatment and the ammonia treatment were not carried out, and due to using an integral method, the silane coupling agent treatment was not carried out.

(Comparative Example 5)

A specimen of silica-coated aluminum nitride particles A obtained by surface treating with a silane coupling agent the silica-coated aluminum nitride particles A was obtained by operating in the same manner as Example 1, except that the CVD treatment and the ammonia treatment were not carried out, a dry mixing method instead of an immersion method was used as the method for mixing the silane coupling agent, and the charging ratio of the silane coupling agent was set to 3.

(Comparative Example 6)

A specimen of silica-coated aluminum nitride particles A obtained by surface treating with a silane coupling agent the silica-coated aluminum nitride particles A was obtained by operating in the same manner as Example 1, except that the CVD treatment and the ammonia treatment were not carried out, SZ-31 instead of KBM-3103 was used as the silane coupling agent, and the charging ratio of the silane coupling agent was set to 5.

(Comparative Example 7)

A specimen of silica-coated aluminum nitride particles A obtained by surface treating with a silane coupling agent the silica-coated aluminum nitride particles A was obtained by operating in the same manner as Example 1, except that the ammonia treatment was not carried out, SZ-31 instead of KBM-3103 was used as the silane coupling agent, and the charging ratio of the silane coupling agent was set to 5.

(Comparative Example 8)

A specimen was obtained by operating in the same manner as Example 9, except that the CVD treatment, ammonia treatment, and silane coupling agent treatment were not carried out on silica-coated aluminum nitride particles B.

(Comparative Example 9)

A specimen of silica-coated aluminum nitride particles B obtained by surface treating with a silane coupling agent the silica-coated aluminum nitride particles A was obtained by operating in the same manner as Example 1, except that the silica-coated aluminum nitride particles A were changed to the silica-coated aluminum nitride particles B, the CVD treatment and the ammonia treatment were not carried out, and the charging ratio of the silane coupling agent was set to 2.

(Comparative Example 10)

A specimen of boron particles A obtained by surface treating with a silane coupling agent the boron nitride particles A was obtained by operating in the same manner as Example 1, except that the silica-coated aluminum nitride particles A were changed to the boron nitride particles A, the CVD treatment and the ammonia treatment were not carried out, and the charging ratio of the silane coupling agent was set to 2.

(Comparative Example 11)

A specimen of boron nitride particles B obtained by surface treating with a silane coupling agent the boron nitride particles B was obtained by operating in the same manner as Example 1, except that the silica-coated aluminum nitride particles A were changed to the boron nitride particles B, the CVD treatment and the ammonia treatment were not carried out, and the charging ratio of the silane coupling agent was set to 2.

[Measurement of carbon atom content (ΔT-C)]

The carbon atom content of the specimens obtained in the examples and comparative examples was measured using a carbon/sulfur analyzer (Carbon Analyzer EMIA-821, manufactured by Horiba, Ltd.) by a non-dispersive infrared

absorption method using a tubular electric furnace to measure the carbon content of the specimens before and after the (silanol group introduction and subsequent surface treatment agent), and taking the increase in carbon (% by mass) in the silanol group introduction and subsequent surface treatment steps as ΔT-C. The value of the increase in carbon was used as a guideline for the amount of surface treatment agent attached. The results are shown in Tables 1 and 2.

[Measurement of slurry flow viscosity]

- Examples 1 to 8 and 12, and Comparative Examples 1 to 3 and 5 to 7

The particles obtained in each of Examples 1 to 8 and 12 and Comparative Examples 1 to 3 and 5 to 7 were set in a 150 ml dedicated plastic container together with aluminum nitride particles TFZ-S30P, alumina particles AA-3, alumina particles AA-18, zinc oxide HD-01, silicone oil TSF458-50, and silicone resin raw material EG-3100 (A) so as to obtain the slurry compositions (parts by mass) shown in Tables 1 and 2. Using a planetary centrifugal mixer (manufactured by Thinky Co., Ltd., trade name: ARV-310P), the resultant mixture was stirred and mixed 6 times at a rotation speed of 1500 rpm for 30 seconds and 3 times at a rotation speed of 2000 rpm for 30 seconds while reducing the pressure to obtain a slurry. The flow viscosity of the obtained slurry was measured using a flow tester (manufactured by Shimadzu Corporation, model name: "CFT-EX") under conditions of a nozzle of φ2×2 mmL, 30°C, and 40 kg load. The results are shown in Tables 1 and 2.

The details of each component are as follows.

- TFZ-S30P: Insulating aluminum nitride thermally conductive filler (trade name: Toyal Tecfiller, manufactured by Toyo Aluminum K.K., D50 = 30 μm)
- AA-3: High-purity alumina (trade name: Advanced Alumina (registered trademark), manufactured by Sumitomo Chemical Co., Ltd., D50 = 3 μm)
- AA-18: High-purity alumina (trade name: Advanced Alumina, manufactured by Sumitomo Chemical Co., Ltd., D50 = 18 μm)
- HD-01: Zinc oxide (trade name: Developmental Product, manufactured by Hakusui Tech Co., Ltd., D50 = 0.5 μm)
- TSF458-50: Heat-resistant oil (trade name: Straight silicone oil, manufactured by Momentive Co., Ltd.)
- EG-3100 (A): Silicone resin raw material (trade name: DOWSIL (registered trademark) EG-3100, manufactured by Dow Toray Co., Ltd.) liquid A (viscosity 420 mPa·s, mixture of vinyl oil and platinum catalyst)
- Comparative example 4

Among the components of the slurry composition (parts by mass) listed in Table 2, the liquid components, namely, the silicone resin raw material EG-3100 (A) and the silicone oil TSF458-50, and the silane coupling agent KBM3103 in an amount three times that capable of coating 43.6 parts of the nitride filler determined from the minimum coating area described in Example 1, were set in a 150 ml dedicated plastic container, and the resultant mixture was stirred and mixed once at a rotation speed of 2000 rpm for 30 seconds using a planetary centrifugal mixer (manufactured by Thinky Co., Ltd., trade name: ARV-310P). To the mixture, the particles of Comparative Example 4, aluminum nitride particles TFZ-S30P, alumina particles AA-3, alumina particles AA-18, zinc oxide HD-01were added so as to obtain the slurry compositions (parts by mass) shown in Table 2. Using the planetary centrifugal mixer (manufactured by Thinky Co., Ltd., trade name: ARV-310P), the resultant mixture was stirred and mixed 6 times at a rotation speed of 1500 rpm for 30 seconds and 3 times at a rotation speed of 2000 rpm for 30 seconds while reducing the pressure to obtain a slurry. The flow viscosity of the obtained slurry was measured using a flow tester (manufactured by Shimadzu Corporation, model name: "CFT-EX") under conditions of a nozzle of φ2×2 mmL, 30°C, and 40 kg load. The results are shown in Table 2.

The details of each component in Comparative Example 4 were the same as those described for Examples 1 to 8 and 12 and Comparative Examples 1 to 3 and 5 to 7.

Example 9, and Comparative Examples 8 and 9

The particles obtained in each of Example 9 and Comparative Examples 8 and 9 were set in a 150 ml dedicated plastic container together with high-purity alumina AKP-30 and the silicone resin raw material EG-3100 (A) so as to obtain the slurry compositions (parts by mass) shown in Tables 1 and 2. Using a planetary centrifugal mixer (manufactured by Thinky Co., Ltd., trade name: ARV-310P), the resultant mixture was stirred and mixed 6 times at a rotation speed of 1500 rpm for 30 seconds and 3 times at a rotation speed of 2000 rpm for 30 seconds while reducing the pressure to obtain a slurry. The flow viscosity of the obtained slurry was measured using a flow tester (manufactured by Shimadzu Corporation, model name: "CFT-EX") under conditions of a nozzle of φ2×2 mmL, 30°C, and 40 kg load. The results are shown in Tables 1 and 2.

The details of each component are as follows.

- AKP-30: High-purity alumina (trade name: AKP Series, manufactured by Sumitomo Chemical Co., Ltd., D50 = 0.26 μm)
- EG-3100 (A): Silicone resin raw material (trade name: DOWSIL (registered trademark) EG-3100, manufactured by Dow Toray Co., Ltd.) liquid A (viscosity 420 mPa·s, mixture of vinyl oil and platinum catalyst)

Example 10 and Comparative Example 10

The particles obtained in each of Example 10 and Comparative Example 10 and a silicone oil (trade name KF-96-1000cs, Shin-Etsu Chemical Co., Ltd.) were set in a 150 ml dedicated plastic container so as to obtain the slurry compositions (parts by mass) shown in Tables 1 and 2. Using a planetary centrifugal mixer (manufactured by Thinky Co., Ltd., trade name: ARV-310P), the resultant mixture was stirred and mixed once at a rotation speed of 1500 rpm for 30 seconds and 2 times at a rotation speed of 2000 rpm for 30 seconds while reducing the pressure to obtain a slurry. The flow viscosity of the obtained slurry was measured using a flow tester (manufactured by Shimadzu Corporation, model name: "CFT-EX") under conditions of a nozzle of φ0.5×1 mmL, 30°C, and 80 kg load. The results are shown in Tables 1 and 2.

Example 11 and Comparative Example 11

The particles obtained in each of Example 11 and Comparative Example 11 and a silicone oil (trade name KF-96-1000cs, Shin-Etsu Chemical Co., Ltd.) were set in a 150 ml dedicated plastic container so as to obtain the slurry compositions (parts by mass) shown in Tables 1 and 2. Using a planetary centrifugal mixer (manufactured by Thinky Co., Ltd., trade name: ARV-310P), the resultant mixture was stirred and mixed 3 times at a rotation speed of 1500 rpm for 30 seconds while reducing the pressure to obtain a slurry. The flow viscosity of the obtained slurry was measured using a flow tester (manufactured by Shimadzu Corporation, model name: "CFT-EX") under conditions of a nozzle of φ0.5×1 mmL, 30°C, and 60 kg load. The results are shown in Tables 1 and 2.

[Measurement of average surface density of silanol groups]

The average surface density of silanol groups of each specimen obtained in the examples and the comparative examples was measured as follows.

First, 1 g of the specimen was uniformly dispersed in a solution composed of 25 ml of chloroform and 2 ml of pyridine. Next, 0.1 mg of trifluoroacetic anhydride was added to the resulting dispersed solution, the mixture was stirred at 20°C for 1 hour, and further stirred at 40°C for 2 hours to thoroughly cause the components to react. Then, solids were filtered off and dried at 120°C for 2 hours. The specimens that had been subjected to the above-described treatment were analyzed by X-ray photoelectric spectroscopy using a photoelectron spectrometer (model name: JPS-9030, manufactured by JEOL Ltd.) to quantify fluorine atoms, and the number of silanol groups per unit area was calculated from the number of moles of fluorine atoms present as the average surface density of silanol groups (groups/$nm^2$). The results are shown in Tables 1 and 2.

[Table 1]

Table 1

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Nitride filler type | | Aluminum nitride particles A (FAN-f80-A1) [particle size (D50): 80 μm] | | | | | | | | | | | | |
| | | Aluminum nitride particles B (TFZ-NO1P) [particle size (D50): 1.0 μm] | | | | | | | | | | | | |
| | | Boron nitride particles A (UHP-1K) [particle size (D50): 8.5 μm] | | | | | | | | | | ○ | | |
| | | Boron nitride particles B (UHP-S2) [particle size (D50): 1.0 μm] | | | | | | | | | | | ○ | |
| | | Silica-coated aluminum nitride particles A [particle size (D50): 80 μm] | ○ | ○ | ○ | ○ | ○ | ○ | ○ | ○ | | | | ○ |
| | | Silica-coated aluminum nitride particles B [particle size (D50): 1.0 μm] | | | | | | | | | ○ | | | |
| Treatment | | Organosilicone compound (D4H) CVD treatment conditions | CVD1 | CVD2 | CVD3 | CVD1 | CVD4 | CVD4 | CVD5 | CVD4 | CVD4 | CVD4 | CVD4 | CVD4 |
| | | Basic substance (ammonia) treatment method | immersion method-1 | immersion method-1 | immersion method-1 | immersion method-2 | vapor-phase deposition method | immersion method-1 | vapor-phase simultaneous deposition method | vapor-phase deposition method | vapor-phase deposition method | vapor-phase deposition method | vapor-phase deposition method | vapor-phase deposition method |
| | | Ammonia treatment temperature [°C] | room temperature | room temperature | room temperature | room temperature | room temperature | room temperature | 60 | 50 | 50 | 50 | 50 | 50 |
| | | Ammonia treatment time [hr] | 24 | 24 | 24 | 24 | 24 | 24 | 4 | 4 | 4 | 4 | 4 | 4 |
| | | Silane coupling agent treatment condition | SC1 | SC1 | SC1 | SC1 | SC1 | SC2 | SC1 | SC1 | SC1 | SC1 | SC1 | - |
| | | Silane coupling agent charging ratio [times] | 90 | 90 | 90 | 90 | 90 | 5 | 90 | 90 | 2 | 2 | 2 | - |
| Evaluation | Slurry composition (parts by mass) | Particles | 43.6 | 43.6 | 43.6 | 43.6 | 43.6 | 43.6 | 43.6 | 43.6 | 60.6 | 67.5 | 70.9 | 43.6 |
| | | Silicone resin raw material EG-3100(A) | 2.9 | 2.9 | 2.9 | 2.9 | 2.9 | 2.9 | 2.9 | 2.9 | 12.1 | | | 2.9 |
| | | Silicone oil KF-96-1000CS | | | | | | | | | | 32.5 | 29.1 | |
| | | Insulating aluminum nitride thermally conductive filler TFZ-S30P | 6.6 | 6.6 | 6.6 | 6.6 | 6.6 | 6.6 | 6.6 | 6.6 | | | | 6.6 |
| | | High-purity alumina AA-3 | 17.7 | 17.7 | 17.7 | 17.7 | 17.7 | 17.7 | 17.7 | 17.7 | | | | 17.7 |
| | | High-purity alumina AA-18 | 2.9 | 2.9 | 2.9 | 2.9 | 2.9 | 2.9 | 2.9 | 2.9 | | | | 2.9 |
| | | Zinc oxide HD-01 | 25.6 | 25.6 | 25.6 | 25.6 | 25.6 | 25.6 | 25.6 | 25.6 | | | | 25.6 |
| | | Heat-resistant oil TSF458-50 | 0.7 | 0.7 | 0.7 | 0.7 | 0.7 | 0.7 | 0.7 | 0.7 | | | | 0.7 |
| | | High-purity alumina AKP-30 | | | | | | | | | 27.3 | | | |
| | Slurry flow viscosity [Pa·s] | | 850 | 1000 | 1100 | 1100 | 1500 | 1500 | 1100 | 1000 | 1500 | 3400 | 2800 | 2500 |
| | Increase in carbon ΔT-C [%] | | 0.073 | 0.050 | 0.084 | 0.166 | 0.049 | 0.021 | 0.030 | 0.066 | 0.223 | 0.440 | 1.193 | - |
| | Average surface density of silanol groups on surface of filler (filler type) (groups/$nm^2$) | | 0.9 | 0.8 | 0.8 | 1.0 | 0.9 | 0.8 | 0.9 | 0.9 | 1.3 | 0.9 | 0.8 | 0.9 |

[Table 2]

Table 2

| | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 |
|---|---|---|---|---|---|---|---|---|---|---|---|---|---|
| Nitride filler type | | Aluminum nitride particles A (FAN-f80-A1) [particle size (D50): 80 μm] | | | ○ | | | | | | | | |
| | | Aluminum nitride particles B (TFZ-NO1P) [particle size (D50): 1.0 μm] | | | | | | | | | | | |
| | | Boron nitride particles A (UHP-1K) [particle size (D50): 8.5 μm] | | | | | | | | | | ○ | |
| | | Boron nitride particles B (UHP-S2) [particle size (D50): 1.0 μm] | | | | | | | | | | | ○ |
| | | Silica-coated aluminum nitride particles A [particle size (D50): 80 μm] | ○ | ○ | | ○ | ○ | ○ | ○ | | | | |
| | | Silica-coated aluminum nitride particles B [particle size (D50): 1.0 μm] | | | | | | | | ○ | ○ | | |
| Treatment | | Organosilicone compound (D4H) CVD treatment conditions | - | CVD1 | - | - | - | - | CVD1 | - | - | - | - |
| | | Basic substance (ammonia) treatment method | - | - | - | - | - | - | - | - | - | - | - |
| | | Ammonia treatment temperature [°C] | - | - | - | - | - | - | - | - | - | - | - |
| | | Ammonia treatment time [hr] | - | - | - | - | - | - | - | - | - | - | - |
| | | Silane coupling agent treatment condition | SC1 | SC1 | SC1 | SC3 | SC4 | SC2 | SC2 | - | SC1 | SC1 | SC1 |
| | | Silane coupling agent charging ratio [times] | 90 | 90 | 90 | 3 | 3 | 5 | 5 | - | 2 | 2 | 2 |
| Evaluation | Slurry composition (parts by mass) | Particles | 43.6 | 43.6 | 43.6 | 43.6 | 43.6 | 43.6 | 43.6 | 60.6 | 60.6 | 67.5 | 70.9 |
| | | Silicone resin raw material EG-3100(A) | 2.9 | 2.9 | 2.9 | 2.9 | 2.9 | 2.9 | 2.9 | 12.1 | 12.1 | | |
| | | Silicone oil KF-96-1000CS | | | | | | | | | | 32.5 | 29.1 |
| | | Insulating aluminum nitride thermally conductive filler TFZ-S30P | 6.6 | 6.6 | 6.6 | 6.6 | 6.6 | 6.6 | 6.6 | | | | |
| | | High-purity alumina AA-3 | 17.7 | 17.7 | 17.7 | 17.7 | 17.7 | 17.7 | 17.7 | | | | |
| | | High-purity alumina AA-18 | 2.9 | 2.9 | 2.9 | 2.9 | 2.9 | 2.9 | 2.9 | | | | |
| | | Zinc oxide HD-01 | 25.6 | 25.6 | 25.6 | 25.6 | 25.6 | 25.6 | 25.6 | | | | |
| | | Heat-resistant oil TSF458-50 | 0.7 | 0.7 | 0.7 | 0.7 | 0.7 | 0.7 | 0.7 | | | | |
| | | High-purity alumina AKP-30 | | | | | | | | 27.3 | 27.3 | | |
| | Slurry flow viscosity [Pa·s] | | 2800 | 2800 | 1800 | 2100 | 2400 | 2100 | 2400 | 2900 | 2800 | 3700 | 3400 |
| | Increase in carbon ΔT-C [%] | | 0.028 | 0.031 | 0.053 | - | 0.079 | 0.007 | 0.017 | - | 0.215 | 0.398 | 1.452 |
| | Average surface density of silanol groups on surface of filler (filler type) (groups/$nm^2$) | | 0.1 | 0.1 | 0.2 | 0.1 | 0.1 | 0.1 | 0.1 | 0.2 | 0.2 | 0.1 | 0.1 |

[Table 3]

Table 3

| CVD treatment | | | | |
|---|---|---|---|---|
| Treatment name | D4H Partial vapor pressure | Treatment temperature (°C) | Treatment time (hours) | Other |
| CVD1 | $1.30\times10^4$Pa | 80 | 7.5 | - |
| CVD2 | $8.12\times10^2$Pa | 80 | 1 | - |
| CVD3 | $2.03\times10^2$Pa | 80 | 1 | - |
| CVD4 | $1.30\times10^4$Pa | 80 | 4 | - |
| CVD5 | $7.66\times10^2$Pa | 60 | 4 | co-existence with 1 N ammonia |
| Common condition: Treatment carried out in an 8 L SUS container in a static sealed state | | | | |

[Table 4]

Table 4

| Basic substance (ammonia) treatment | |
|---|---|
| Treatment method | Treatment details |
| immersion method-1 | immersing in 1 N ammonia water / stirring / standing / filtering / drying |
| immersion method-2 | immersing in ethanol:1 N ammonia water (1:1) / stirring / standing / filtering / drying |
| vapor-phase deposition method | 1 N ammonia water CVD |
| vapor-phase simultaneous deposition method | (D4H / 1 N ammonia water) Co-existing simultaneous CVD |

[Table 5]

Table 5

| Silane coupling agent treatment | | |
|---|---|---|
| Treatment name | Silane coupling agent | Mixing method |
| SC1 | KBM-3103 | impregnation method |
| SC2 | SZ-31 | impregnation method |
| SC3 | KBM-3103 | integral method |
| SC4 | KBM-3103 | dry mixing method |
| Common condition: Surface treatment performed, then left to stand for 2 hours at room temperature to dry, and heat-treated for 2 hours at 120°C | | |

It can be seen that in Examples 1 to 9 (in which aluminum nitride particles were used as the nitride filler), the slurry flow viscosity can be controlled to a low level and the nitride filler can be mixed at a high filling rate by coating more surface treatment agent uniformly on the nitride filler surface by, in the second step A of the method for producing an organosilicon-containing compound-coated nitride filler having a silanol group, or the second step B of the method for producing an

organosilicon-containing compound-coated silica-coated nitride filler having a silanol group, by using an immersion method, a vapor-phase deposition method, or a vapor-phase simultaneous deposition method as the treatment method of the basic substance, and then performing the surface treatment.

On the other hand, in Comparative Examples 1 to 9 (which did not have a silanol group), in which at least an immersion method, vapor-phase deposition method, or vapor-phase simultaneous deposition method was not performed as a treatment method of a basic substance, it can be seen that even when a surface treatment was performed, the slurry flow viscosity was high, the slurry flow viscosity could not be controlled to a low level, and the nitride filler could not be mixed at a high filling rate.

Further, compared with Examples 10 and 11 (which used boron nitride particles as the nitride filler) in which a vapor-phase deposition method was performed using a basic substance after treatment with an organosilicon compound, it can be seen that Comparative Examples 10 and 11, which used boron nitride without treatment, had a higher slurry viscosity and that the nitride filler could not be mixed at a high filling rate.

In addition, it can be seen that the average surface density of silanol groups on the surface of the filler (filler type) of Examples 1 to 11 is higher than the average surface density of silanol groups on the surface of the filler (filler type) of Comparative Examples 1 to 11.

The silanol groups on the filler surface tend to bond by fusing with the silane coupling agent, and this is presumed to efficiently bring out the inherent performance of the silane coupling agent and contribute to reducing the slurry flow viscosity.

## Claims

1. A method for producing an organosilicon-containing compound-coated nitride filler having a silanol group, which comprises a nitride filler and an organosilicon-containing compound film that covers a surface of the nitride filler and has a silanol group on a surface, the method comprising:

   a first step A of covering the surface of the nitride filler with an organosilicone compound containing a structure represented by the following formula (1) to obtain an organosilicon-containing compound-coated nitride filler covered with the organosilicone compound, and a second step A of treating the surface of the organosilicon-containing compound-coated nitride filler with a basic substance to obtain an organosilicon-containing compound-coated nitride filler having a silanol group on the surface, or

   a first step P of causing an organosilicone compound containing a structure represented by the following formula (1) and the basic substance to coexist in the same atmosphere, and simultaneously treating the organosilicone compound and the basic substance to cover the surface of the nitride filler, thereby obtaining an organosilicon-containing compound-coated nitride filler having a silanol group on the surface,

   [Formula 1]

   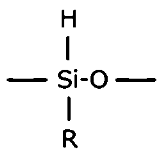 · · · (1)

   wherein, in formula (1), R is an alkyl group having from 1 to 4 carbon atoms.

2. The method for producing an organosilicon-containing compound-coated nitride filler having a silanol group according to claim 1, wherein in the second step A, the basic substance is ammonia water, and the treatment is performed by immersion in the ammonia water.

3. The method for producing an organosilicon-containing compound-coated nitride filler having a silanol group according to claim 1, wherein in the second step A, the basic substance is ammonia water, and the treatment is performed by a chemical vapor deposition (CVD) method.

4. The method for producing an organosilicon-containing compound-coated nitride filler having a silanol group according to claim 1, wherein in the first step P, the basic substance is ammonia water, and the treatment is performed by a chemical vapor deposition (CVD) method simultaneously with the organosilicone compound.

**5.** The method for producing an organosilicon-containing compound-coated nitride filler having a silanol group according to claim 1, wherein the nitride filler is aluminum nitride particles or boron nitride particles.

**6.** The method for producing an organosilicon-containing compound-coated nitride filler having a silanol group according to claim 5, wherein a cumulative volume 50% particle size (D50) of the aluminum nitride particles is 0.1 $\mu$m or more and 200 $\mu$m or less.

**7.** The method for producing an organosilicon-containing compound-coated nitride filler having a silanol group according to claim 1, wherein a surface treatment agent is attached to the surface of the organosilicon-containing compound-coated nitride filler having a silanol group by a reaction or an interaction.

**8.** The method for producing an organosilicon-containing compound-coated nitride filler having a silanol group according to claim 7, wherein the surface treatment agent is a silane coupling agent.

**9.** An organosilicon-containing compound-coated nitride filler having a silanol group, comprising:

a nitride filler; and
an organosilicon-containing compound film that covers a surface of the nitride filler and has silanol groups on the surface in an average surface density of from 0.5 to 2.1 groups/$nm^2$.

**10.** The organosilicon-containing compound-coated nitride filler having a silanol group according to claim 9, further comprising a surface treatment agent on the surface of the organosilicon-containing compound-coated nitride filler having a silanol group.

**11.** The organosilicon-containing compound-coated nitride filler having a silanol group according to claim 10, wherein the surface treatment agent is a silane coupling agent.

**12.** A method for producing an organosilicon-containing compound-coated silica-coated nitride filler having a silanol group, which comprises a silica-coated nitride filler and an organosilicon-containing compound film that covers a surface of the silica-coated nitride filler and has a silanol group on a surface, the method comprising:

a first step B of covering the surface of the silica-coated nitride filler with an organosilicone compound containing a structure represented by the following formula (1) to obtain an organosilicon-containing compound-coated silica-coated nitride filler covered with the organosilicone compound, and a second step B of treating the surface of the organosilicon-containing compound-coated silica-coated nitride filler with a basic substance to obtain an organosilicon-containing compound-coated silica-coated nitride filler having a silanol group on the surface, or a first step Q of causing an organosilicone compound containing a structure represented by the following formula (1) and the basic substance to coexist in the same atmosphere, and simultaneously treating the organosilicone compound and the basic substance to cover the surface of the silica-coated nitride filler, thereby obtaining an organosilicon-containing compound-coated silica-coated nitride filler having a silanol group on the surface,

[Formula 2]

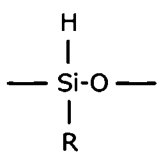

· · · (1)

wherein, in formula (1), R is an alkyl group having from 1 to 4 carbon atoms.

**13.** The method for producing an organosilicon-containing compound-coated silica-coated nitride filler having a silanol group according to claim 12, wherein in the second step B, the basic substance is ammonia water, and the treatment is performed by immersion in the ammonia water.

**14.** The method for producing an organosilicon-containing compound-coated silica-coated nitride filler having a silanol group according to claim 12, wherein in the second step B, the basic substance is ammonia water, and the treatment is performed by a chemical vapor deposition (CVD) method.

15. The method for producing an organosilicon-containing compound-coated silica-coated nitride filler having a silanol group according to claim 12, wherein in the first step Q, the basic substance is ammonia water, and the treatment is performed by a chemical vapor deposition (CVD) method simultaneously with the organosilicone compound.

16. The method for producing an organosilicon-containing compound-coated silica-coated nitride filler having a silanol group according to claim 12, wherein the nitride filler is aluminum nitride particles or boron nitride particles.

17. The method for producing an organosilicon-containing compound-coated silica-coated nitride filler having a silanol group according to claim 16, wherein a cumulative volume 50% particle size (D50) of the aluminum nitride particles is 0.1 μm or more and 200 μm or less.

18. The method for producing an organosilicon-containing compound-coated silica-coated nitride filler having a silanol group according to claim 12, wherein a surface treatment agent is attached to the surface of the organosilicon-containing compound-coated silica-coated nitride filler having a silanol group by a reaction or an interaction.

19. The method for producing an organosilicon-containing compound-coated silica-coated nitride filler having a silanol group according to claim 18, wherein the surface treatment agent is a silane coupling agent.

20. An organosilicon-containing compound-coated silica-coated nitride filler having a silanol group, comprising:

a silica-coated nitride filler; and
an organosilicon-containing compound film that covers a surface of the silica-coated nitride filler and has silanol groups on the surface in an average surface density of from 0.5 to 2.1 groups/$nm^2$.

21. The organosilicon-containing compound-coated silica-coated nitride filler having a silanol group according to claim 20, further comprising a surface treatment agent on the surface of the organosilicon-containing compound-coated silica-coated nitride filler having a silanol group.

22. The organosilicon-containing compound-coated silica-coated nitride filler having a silanol group according to claim 21, wherein the surface treatment agent is a silane coupling agent.

## INTERNATIONAL SEARCH REPORT

International application No.
**PCT/JP2024/034033**

**A. CLASSIFICATION OF SUBJECT MATTER**

***C01B 21/072***(2006.01)i; ***C01B 21/064***(2006.01)i; ***C08K 9/06***(2006.01)i; ***C08L 101/00***(2006.01)i; ***C09C 3/08***(2006.01)i; ***C23C 16/42***(2006.01)i
FI: C01B21/072 Z; C01B21/064 Z; C23C16/42; C08K9/06; C08L101/00; C09C3/08

According to International Patent Classification (IPC) or to both national classification and IPC

**B. FIELDS SEARCHED**

Minimum documentation searched (classification system followed by classification symbols)

C01B21/06-21/076; C08K3/00-13/08; C08L1/00-101/14; C09C1/00-3/12;C09D15/00-17/00 ;C23C16/42

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2023-98163 A (RESONAC CORPORATION) 10 July 2023 (2023-07-10) entire text | 1-22 |
| A | WO 2021/006310 A1 (SHOWA DENKO K.K.) 14 January 2021 (2021-01-14) entire text | 1-22 |
| A | JP 2020-125228 A (TOKUYAMA CORPORATION) 20 August 2020 (2020-08-20) entire text | 1-22 |
| A | JP 2021-75435 A (SHOWA DENKO K.K.) 20 May 2021 (2021-05-20) entire text | 1-22 |
| A | JP 2020-193141 A (SHOWA DENKO K.K.) 03 December 2020 (2020-12-03) entire text | 1-22 |
| A | WO 2020/040309 A1 (SHOWA DENKO K.K.) 27 February 2020 (2020-02-27) entire text | 1-22 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 November 2024** | **03 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/034033**

| Patent document cited in search report | Publication date (day/month/year) | Patent family member(s) | Publication date (day/month/year) |
|---|---|---|---|
| JP 2023-98163 A | 10 July 2023 | (Family: none) | |
| WO 2021/006310 A1 | 14 January 2021 | US 2022/0195141 A1<br>entire text<br>EP 003932859 A1<br>entire text<br>CN 113498422 A | |
| JP 2020-125228 A | 20 August 2020 | (Family: none) | |
| JP 2021-75435 A | 20 May 2021 | US 2022/0135805 A1<br>entire text<br>CN 113474411 A | |
| JP 2020-193141 A | 03 December 2020 | US 2021/0309861 A1<br>entire text<br>EP 003842383 A1<br>entire text<br>CN 112585087 A | |
| WO 2020/040309 A1 | 27 February 2020 | US 2021/0309861 A1<br>entire text<br>EP 003842383 A1<br>entire text<br>CN 112585087 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3446053 B
- JP 4088768 B
- JP 4804023 B
- JP 2015071730 A
- WO 2020040309 A1